# EUROPEAN PATENT APPLICATION

(11) **EP 4 521 458 A1**
(43) Date of publication of application: **12.03.2025**
(21) Application number: 24199033.2
(22) Date of filing: 06.09.2024
(51) Int. Cl.: H01L 23/498

(54) **ADVANCED SUBSTRATES FOR LARGE, HIGH PERFORMANCE POWER PACKAGES**

(30) Priority: 11.09.2023 US 202363537666 P; 15.08.2024 US 202418806023
(71) Applicant: Google LLC, Mountain View, CA 94043 (US)
(72) Inventor: MOHAMMED, Ilyas, Mountain View 94043 (US)
(74) Representative: Betten & Resch

(57) **Abstract**

A package substrate for a microelectronic package assembly includes an inorganic core body, such as a ceramic core body, with embedded capacitors and at least one conductive through via extending through the core body. The structure of the inorganic core body allows for at least one redistribution layer to be built-up directly onto the inorganic core body, without the use of an intermediate carrier or interposer.

## Description

### CROSS-REFERENCE TO RELATED APPLICATIONS

The present application claims the benefit of the filing date of U.S. Provisional Patent Application No. 63/537,666 filed September 11, 2023, the disclosure of which is hereby incorporated herein by reference.

### BACKGROUND

As computer power and performance requirements for high performance computing ("HPC") chips and integrated circuit ("IC") chips increase, unique challenges are placed on the design, manufacture, and performance of semiconductor chip packages. Traditionally, semiconductor packages consisted of a single semiconductor chip that is mechanically bonded to the substrate and electrically connected through interconnects such as wire-bonds and flip-chip bumps. Due to these increasing performance demands, more chips are being integrated within a package. Chips have been incorporated into the same package either by placing them next to each other or on top of each other to achieve higher density and performance. The increase in the number of chips necessarily leads to an increase in package size, but lower assembly yield and reliability.

One industry approach is to use organic substrates in combination with discrete interposers (either silicon or organic), as well as discrete capacitors on one or both sides of the substrate. The highest performance packages are built hierarchically by first placing all of the chips or packages on the interposer or carrier substrate, which is then placed onto the package substrate. The package substrate cannot meet the high-density routing requirements, thereby requiring the use of a special carrier substrate with very fine metal interconnects. The special carrier substrate is commonly made using silicon wafer equipment and processes.

The organic package substrate, however, has lower stiffness leading to higher warpage or deformation, as well as coarser interconnect routing requiring the use of a discrete interposer. A warped package leads to a non-uniform thermal interface material ("TIM") thickness, which impacts thermal performance. Additionally, the likelihood of warpage requires the use of external devices to control the warpage and enable smooth processing through assembly and testing. Stiffeners are commonly used to manage package deformation, but they take up space on the package substrate and within the overall package assembly.

### BRIEF SUMMARY

Microelectronic element package assemblies are disclosed that implement an improved package substrate. The package substrate can provide fine routing capability, which eliminates the need for a carrier interposer. The package substrate further provides greater stiffness to minimize warpage and eliminate the need for a stiffener in the package, thereby freeing more space for other components, such as capacitors for power management. The package substrate further provides higher thermal performance, allowing for the uniform spread of heat. The package substrate further provides for additional space for capacitive elements that allow for an overall smaller and/or more compact package. The package substrate also allows for building redistribution layers directly on a core body, which eliminates the need for use of an intermediate carrier substrate to transfer the redistribution layer for attachment to the primary core substrate. These and other improvements further lead to minimizing package size, providing for efficient use of space on surfaces of the substrate, and improving the overall manufacturing process.

According to an aspect of the disclosure, a package substrate for a microelectronic package assembly includes an inorganic core body having a top surface and a bottom surface; at least one core via extending through the top and bottom surfaces of the core body; at least one built-up redistribution layer built up on one of the top surface or the bottom surface of the inorganic core body, and at least one capacitor structure embedded within the inorganic core body and extending between the top and bottom surfaces of the inorganic core body. The redistribution layer may include at least one dielectric layer, a plurality of conductive traces and contacts overlying the at least one dielectric layer, and redistribution vias extending through the at least one dielectric layer. The at least one capacitor structure may further include at least two conductive layers and a capacitor dielectric layer disposed between the at least two conductive layers. The at least one core via may conductively connect first terminals disposed at a top surface of the substrate with second terminals disposed at a bottom surface of the substrate.

According to another aspect of the disclosure, a microelectronic package assembly includes a package substrate; and at least one integrated circuit chip bonded to the substrate. The at least one integrated circuit chip is conductively connected to at least one of the conductive traces disposed at the substrate. The package substrate further includes an inorganic core body having a top surface and a bottom surface; at least one core via extending through the top and bottom surfaces of the core body; at least one built-up redistribution layer built up on one of the top surface or the bottom surface of the inorganic core body, and at least one capacitor structure embedded within the inorganic core body and extending between the top and bottom surfaces of the inorganic core body. The redistribution layer may include at least one dielectric layer, a plurality of conductive traces and contacts overlying the at least one dielectric layer, and redistribution vias extending through the at least one dielectric layer. The at least one capacitor structure may further include at least two conductive layers and a capacitor dielectric layer disposed between the at least two conductive layers. The at least one core via may conductively connect first terminals disposed at a top surface of the substrate with second terminals disposed at a bottom surface of the substrate.

According to still another aspect of the disclosure, a method of manufacturing a package substrate for a chip package assembly includes forming one or more capacitor structures within an inorganic core body; forming a conductive through-via within one of the plurality of openings that extends through the top surface and bottom surface of the core body; and building a redistribution layer directly onto the inorganic core body. The forming one or more capacitor structures within an inorganic core body may further include depositing a first conductive layer along an interior surface of a plurality of openings within the core body; depositing a second dielectric layer within the plurality of openings, the dielectric layer overlying the first conductive layer, the dielectric layer comprising a dielectric material having a high dielectric constant; and filling a remainder of the plurality of openings with a third conductive layer, such that the third conductive layer is insulated from the first conductive layer by the second dielectric layer. The building a redistribution layer directly onto the inorganic core body may further include depositing a dielectric layer directly onto the core body; patterning the dielectric layer to form a plurality of openings; and filling the openings with conductive material to form conductive interconnections.

According to yet another aspect of the disclosure, a package substrate for a microelectronic package assembly includes an inorganic core body having a top surface and an opposed bottom surface, a first built-up redistribution layer comprising at least one dielectric layer and at least one conductive component disposed within the at least one dielectric layer, and a second built-up redistribution layer directly built up onto the second surface of the core body. The core body may further include a first inorganic sheet having a top surface and an opposed bottom surface. The first inorganic sheet may further include at least one first sheet via extending through the top and bottom surfaces; and at least one capacitor structure having a total length extending between the top and bottom surfaces of the first organic sheet. The total length may be at least 5% of a total length of the first inorganic sheet between the top surface and the bottom surface of the first inorganic sheet. The second inorganic sheet may have a top surface and an opposed bottom surface. The second inorganic sheet may be joined to the first inorganic sheet and include at least one second sheet via extending through the top and bottom surfaces of the second inorganic sheet. The at least one dielectric layer and the at least one conductive component manufactured being built up onto the first surface of the core body.

### BRIEF DESCRIPTION OF THE DRAWINGS

FIG. 1 is a schematic cross-sectional view of a microelectronic element package according to an aspect of the disclosure.
FIG. 2 is an enlarged and schematic cross-sectional view of a package substrate according to an aspect of the disclosure.
FIG. 3 is an enlargement of FIG. 2.
FIG. 4 is a schematic view of another package substrate for a microelectronic element package according to another aspect of the disclosure.
FIG. 5 is a schematic view of another package substrate for a microelectronic element package according to another aspect of the disclosure.
FIGS. 6A-6R illustrate an example method for manufacturing a package substrate for a microelectronic package according to an aspect of the disclosure.
FIG. 7A is a schematic view of an example core body of a package substrate according to an aspect of the disclosure.
FIG. 7B is a schematic view of an example sheet with openings that can be used when manufacturing the core body of FIG. 7A.
FIG. 7C is a schematic cross-sectional view of the core body of FIG. 7A.

### DETAILED DESCRIPTION

Microelectronic element package assemblies are disclosed that implement an improved package substrate for supporting microelectronic elements and devices. The package substrate for the package assembly can provide fine routing capability, which eliminates the need for a carrier interposer; higher stiffness to minimize warpage and eliminate the need for a stiffener in the package; higher thermal performance to allow for the uniform spread of heat; and embedded capacitive elements that can allow for a smaller package.

According to an aspect of the disclosure, there is provided a package substrate for a microelectronic package assembly includes an inorganic core body, such as a ceramic core body, with embedded capacitors and at least one conductive through via extending through the core body. The structure of the inorganic core body allows for at least one redistribution layer to be built-up directly onto the inorganic core body, without the use of an intermediate carrier or interposer.

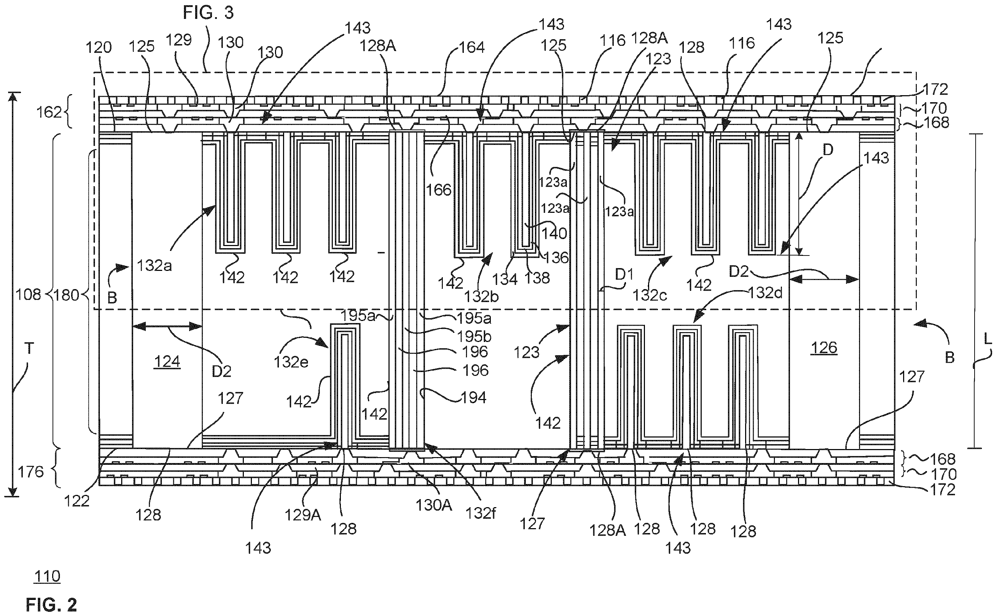

According to an aspect of the disclosure, a microelectronic element package assembly is disclosed that incorporates an improved package substrate to support microelectronic devices, including semiconductor chips, in the assembly. The package substrate allows for a chip package assembly that is compact and configured to accommodate numerous devices for higher performance. The package substrate may be composed of a core body with chip capacitors embedded therein (FIG. 2), as well as redistribution layers with fine routing applied directly to the top and bottom surfaces of the core body. The configuration of package substrate allows for redistribution layers to be directly attached to the package substrate without the use of a carrier substrate, as well as the attachment of integrated circuit ("IC") chips directly to package substrate without the need for an interposer. A package substrate manufactured according to aspects of the disclosure further allows for enhanced warpage control due to the use of ceramic core body, fine routing capability, integrated capacitive elements, and high thermal conductivity.

### EXAMPLE ASSEMBLIES

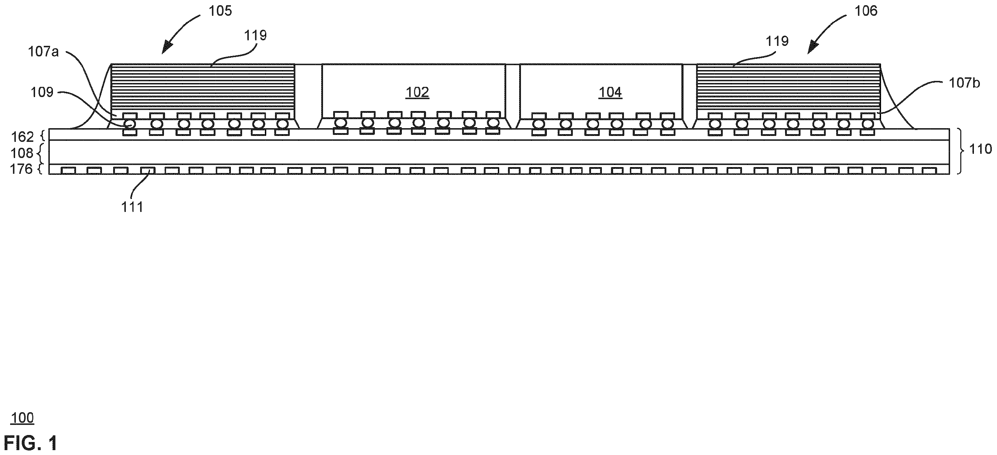

According to an aspect of the disclosure, FIG. 1 discloses an example microelectronic element package assembly, which in this example is a chip package assembly 100 that incorporates an improved package substrate 110 to support microelectronic devices, including semiconductor chips, in the assembly. As shown, use of package substrate 110 allows for a chip package assembly 100 that is compact and configured to accommodate numerous devices for higher performance. In one example, package substrate 110 may include a core body 108 with one or more chip capacitor structures embedded therein (see FIG. 2), as well as a first multi-level redistribution layer 162 and a second multi-level redistribution layer 176, both with fine routing applied directly to the top and bottom surfaces of core body 108. The structure of substrate 110 allows for microelectronic devices to be directly attached to package substrate 110 without the use of a carrier substrate or interposer. First and second central integrated circuit chips 102, 104 may be directly attached to package substrate 110 without the use of a carrier substrate or interposer. In this example, first and second integrated circuit chips 102, 104 may be bonded with solder balls 109 to package substrate 110. Chip package subassemblies may also be attached to package substrate 110, such as the outermost first chip package subassembly 105 and second chip package subassembly 106 positioned at opposed sides of the first and second IC chips 102, 104. The first and second chip package subassemblies 105,106 may include multiple stacked chips 119 arranged one on top of the other and overlie respective first chip subassembly substrate 107a and second chip subassembly substrate 107b, as well as package substrate 110. Terminals 111 may be provided within second redistribution layer 176 to provide for interconnection of package assembly 100 to other components. Package substrate 110, when manufactured according to aspects of the disclosure, further allows for enhanced warpage control due to the use of ceramic core body, fine routing capability, integrated capacitive elements, and high thermal conductivity to help spread heat uniformly.

First and second integrated circuit chips 102, 104 may be any of a variety of different processing units. For example, integrated circuit chips 102, 104 may be central processing units (CPUs), graphics processing units (GPUs), field programmable gate arrays (FPGAs) or application-specific integrated circuits (ASICs), such as tensor processing units (TPUs). In some examples, the integrated circuit chips 102, 104 may be configured for efficient execution of certain types of operations, e.g., operations for accelerating machine learning model inference or training. Example operations include matrix-matrix multiplication, matrix-vector multiplication, quantization, and/or other operations for processing a machine learning model, such as a neural network.

Aspects of the disclosure can allow for higher throughput, such as, during accelerated machine learning inference and training. This can be achieved at least because more operations can be performed per clock cycle without thermal throttling or damage to the package substrate caused by excess heat. Further, more integrated circuit chips can be packaged in the package assembly, due in part to the additional space available on the package substrate through at least the elimination of an interposer and/or capacitors positioned on top and/or bottom surfaces of the package substrate and/or an external stiffener. This can further reduce the overall size of the package assembly.

FIG. 2 is an enlarged view of an example configuration of package substrate 110 that can be implemented within assembly 100 of FIG. 1 or any other chip package assembly. Package substrate 110 includes a core body 108 having a top surface 120 and a bottom surface 122. In this example, core body 108 may include a single ceramic sheet 180 that is processed to include electronic components, but in other examples, core body 108 may include two or more ceramic sheets that are directly or indirectly joined together and processed to include conductive components. For example, contacts 128, including contact pads 128A are disposed at top surface 120 and bottom surface 122 of core body 108. Vias 124, 126 are through vias that extend through core body 108 between top surface 120 and bottom surface 122. Embedded capacitor structures 132a-132f are embedded within package substrate 110. A first multi-level redistribution layer 162 overlies top surface 120 and a second multi-level redistribution layer 176 overlies bottom surface 122.

Core body 108 of package substrate 110 may have a length L that extends from top surface 120 to bottom surface 122. Core body 108 may be comprised of a material, which can be an inorganic material, such as a ceramic material. Numerous ceramic materials can be utilized, including, without limitation, aluminum oxide (Al₂O₃), aluminum nitride (A1N), silicon nitride (Si₃N₄), silicon carbide (SiC), and zirconium oxide (ZrO₂). Use of these ceramic materials to form core body 108 provide modulus of elasticity values of package substrate 110 that is roughly an order of magnitude higher than traditional organic substrate cores and are in the range of 200-400 GPa and the CTE in the 5-10 ppm/ 0° C range. The higher stiffness can provide substantially lower warpage and hence higher assembly yield and product reliability. Furthermore, use of a ceramic material to form core body 108 can help to eliminate the need for a separate stiffener in the chip package assembly.

Improved and high thermal conductivity for package substrate 110 can also be achieved using a core body 108 and package substrate according to aspects of the disclosure. For example, package substrate 110 comprised of a ceramic core body 108, such as disclosed herein, can be configured to achieve substantially high thermal conductivity, such as for example, 10 W/mK or greater. In some examples, thermal conductivity may range from 10-200 W/mK. In other examples, thermal conductivity may be greater than 200 W/mK. The high thermal conductivity achieved for substrates according to aspects of the disclosure provides an improvement over conventional organic substrates, which commonly have low thermal conductivity, typically lower than 1 W/mK. Ceramic core body 108 can further be used as a heat spreader and help to minimize hot spot effects on metal interconnects such as traces, vias, bumps, and solder joints in the package. By reducing the overall peak temperature values of the substrate, electromigration and reliability of the interconnects may be improved. In some examples, an additional heat spreader can also be used in the package assembly.

Package substrate 110 may include one or more through hole conductive vias that extend through core body 108. The vias may be single-hole vias and/or multi-hole vias. Single-hole and multi-hole via openings may be drilled or etched through core body 108 and filled or plated with conductive material, such as known metal and/or alloy materials, including copper and silver. For example, a first via 124 and a second via 126 are single-hole vias that extend between and through top and bottom surfaces 120, 122 of core body 108. Each of first and second vias 124, 126 include a top end 125, a bottom end 127, and an elongated body B therebetween, which in this example is equal to length L of core body 108. First and second vias 124, 126 are formed as single hole openings that are filled with conductive material.

Package substrate 110 may additionally or alternatively include at least one multiple-hole via. For example, via 123 is a multi-hole through via collectively formed from multiple smaller via openings spaced close together and that similarly extend between and through top and bottom surfaces 120, 122 of core body 108. In this example, via 123 includes three openings 123a that may be drilled or otherwise created through core body 108, including ceramic sheet 180, and spaced apart from one another by portions of core body 108. In other examples, a different number of openings 123a may be created. The via openings 123a may each have an individual diameter D1 that is smaller than the diameter D2 of vias 124, 126. Via openings 123a may be filled with conductive material to collectively form multiple-hole via 123.

Each end 125, 127 of corresponding vias 123, 124, 126 may be joined to terminals or traces provided in the first and second multi-level redistribution layers 162, 176 disposed at top surface 120 and bottom surface 122 of core body 108. Upper ends 125 of first, second and third vias 124, 126, 123 may be conductively connected with conductive connections disposed at top surface 120 of core body 108 through exposed portions of vias 124, 126 that form contacts 128 formed at top surface 120 of core body 108. Bottom ends 127 of first and second vias 124, 126 may be similarly conductively connected to conductive connections disposed at bottom surface 122 of core body 108, such as contact pads 128A. In some examples, one of conductive vias 124, 126 may be conductively connected to a power source and the other of the vias 124, 126 may be connected to a ground.

Capacitor structures may be at least partially embedded within the ceramic core body 108 of package substrate 110 and configured to store and release electrical charges. Capacitor structures may be formed within openings created within ceramic core body 108 and may be three-dimensional capacitors designed to extend in a vertical direction through a thickness of core body 108, as opposed to extending in a horizontal direction in a plane parallel to top and bottom surfaces of core body 108. Ceramics are easily etchable to yield ordered pores that are random and highly ordered at both micro-meter and sub-micro-meter diameters. This allows for the easy manufacture of deep partial or through via-like pores or openings in ceramic core body 108 to provide a capacitor structure with substantially higher capacitance density, as compared to conventional metal-insulator-metal capacitors. This is because a capacitor's capacitance value per unit area (area density) is proportional to the area of material stack (conductor-dielectric-conductor), proportional to the dielectric constant of the dielectric, and inversely proportional to the thickness of the dielectric. The capacitor structure is configured to provide maximum capacitance by the use of an increased area, a high-k dielectric constant, and a thin dielectric. Configuring the three-dimensional capacitor in a vertical direction eliminates the need for capacitors to be spread out in a horizontal direction parallel to the top surface, and instead allows for a minimal flat area while providing a high capacitance area. The thickness of the capacitor structure can be utilized, rather than the use of a capacitor structure that extends in a horizontal direction parallel to the top surface of the package substrate.

In this example, all capacitor structures 132a, 132b, 132c, 132d, 132e, and 132f (collectively "capacitor structures 132") are embedded within package substrate 110, and particularly embedded within core body 108. Capacitor structures 132a-132e each extend partially through core body 108. As shown, capacitor structures extend only through top surface 120 and do not extend all the way to and/or through bottom surface 122. Capacitor structures 132a, 132b, 132c may be positioned directly adjacent top surface 120 and capacitor structures 132d, 132e may be positioned directly adjacent bottom surface 122. Capacitor structure 132f is a through capacitor that extends from top surface 120 to bottom surface 122. In other examples, capacitor structures may be partially embedded within core body 108. For example, capacitor structures may extend in a vertical direction into core body 108, which is a direction perpendicular to a top and bottom surface 120, 122 of core body 108. One or more of the capacitor structures may extend a depth D into core body 108. In this example, depth D is approximately 30% of the overall core body 108, but in other examples, depth D may range from 5%-100% of length L of core body 108. In other examples, depth D may be at least 5% of length L of core body 108. In still other examples, capacitor structure may extend a minimum depth D of 5% of overall core body 108. In other examples, capacitors may extend a depth D of 50% or more of ceramic sheet 180.

Capacitor structures 132 can be manufactured to have various configurations. In this example, capacitor structures 132a-132e extend partially through core body 108 and may include one or more extensions or legs. For example, capacitor structures 132a, 132c, 132d each include three legs 142 joined together by a base section 143 that collectively form the shape of the letter "E". Capacitor structures 132b includes two legs 142 joined together by a base section 143 that collectively form the shape of the letter "U." Capacitor structures 132e include a single extension or leg 142 that extends partially through core body 108. Capacitor structure 132f includes a single extension or leg 142 that extends through top surface 120 and bottom surface 122 of core body 108. In this example, capacitor structures each include conductive material separated by a dielectric layer. For example, capacitors 132a-132e may include a first dielectric layer 134, a second dielectric layer 136, a first conductive layer 138 disposed between the first dielectric layer 134 and second dielectric layer 136, and a second conductive layer 140.

The insulating or dielectric material comprising the dielectric layers may be any dielectric material. In this example, first dielectric layer 134 may be comprised of an aluminum oxide or polyimide. The dielectric material selected for second dielectric layer 136 may be a high-k dielectric material or a material having a high dielectric constant, as compared to silicon dioxide. Common high-k dielectric materials can include, without limitation, hafnium dioxide (HfO₂), zirconium dioxide (ZrO₂), and titanium dioxide (TiO₂).

Capacitor structure 132f extends through the entire length L of core body 108, including through top surface 120 and bottom surface 122. Capacitor structure 132f may have an opening that is in the shape of a square or circle or other desired shape. Capacitor structure 132f may have alternating layers of conductive material and insulating or dielectric material. For example, capacitor structure 132f includes a first conductive layer 195a that extends along and around interior surface 194 of core body 108 and a second conductive layer 195b. Second dielectric layer 196 is disposed between first conductive layer 195a and second conductive layer 195b. Capacitor carrier structure 132f differs from other capacitor structures 132a-132e to the extent that the overall length of capacitor structure 132f, which extends through entire length L of core body 108, as well as the fact that capacitor structure 132f extends in only one direction and includes a single leg 142.

Contacts 128 may be positioned at top surface 120 and bottom surface 122 of core body 108. Contacts 128 may be portions of capacitor structures 132a-132f and vias 124, 126, 123 that are exposed at top surface 120 and bottom surface 122 of core body 108. Additional conductive contacts may also be patterned on top and bottom surfaces 120, 122, such as conductive contacts 128A that overlie capacitor 132f and multi-hole through via 123.

Package substrate 110 may further include at least one redistribution layer, which in this example is a multi-level redistribution layer ("multi-level RDL") built directly on top surface 120 or bottom surface 122 of core body 108. Due to core body 108 being formed from a ceramic material, the multi-level RDL can be deposited and built-up directly onto core body 108 without the use of an intermediate carrier layer. It is to be appreciated that depositing or building multi-level RDL onto a surface, such as a surface of core body is not limited to the RDL layers resting on a specific surface of core body 108. For example, without limitation, there may be applications where portions of core body may be recessed or include porous structures that allow for the RDL to be incorporated into or within portions of core body.

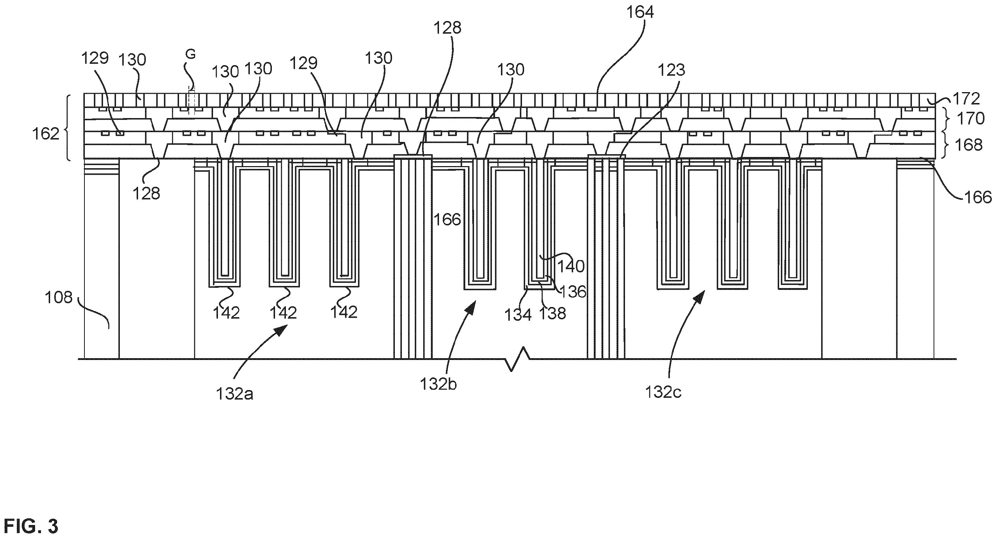

The multi-level RDL may be manufactured in any configuration to include any number of levels and arrangements of vias and traces that will provide an electrical interconnection between and among microelectronic devices conductively connected to the multi-level RDL. In this example, two multi-level RDLs are provided as part of package substrate 110. First multi-level RDL 162 overlies and may be built directly on top surface 120 of core body 108; a second multi-level RDL overlies and may be built directly on bottom surface 122 of core body 108. As best shown in FIG. 3, an enlarged schematic view of a portion of FIG. 2, first multi-level RDL 162 includes top surface 164, bottom surface 166, and several dielectric layers with conductive elements disposed therein. For example, first multi-level RDL 162 includes first level or set of dielectric layers 168, second level or set of dielectric layers 170, and third level or set of dielectric layers 172. RDL vias 130 may be provided in each of first set of dielectric layers 168, second set of dielectric layers 170, and third set of dielectric layers 172 to provide an electrical interconnection with traces 129 in each set of dielectric layers 168, 170. Terminals 116 may be formed by exposed portions of vias 130 in third dielectric layer 172. In other examples, additional contact pads may be formed and overlie terminals 116.

Second multi-level RDL 176 may be directly deposited and built up on bottom surface 122 of core body 108. As with the first multi-level RDL, core body 108 can act as a carrier for second multi-level RDL 176. Core body 108 similarly allows for a second multi-level RDL 176 to be built up directly on bottom surface 122 of core body 108. In this example, second multi-level RDL 176 similarly includes first set of dielectric layers 168, second set of dielectric layers 170, and a third dielectric layer 172. Contact pads 128A may be embedded within the first dielectric layer 168A. RDL vias 130A may be provided in each of first dielectric layer 168A, second dielectric layer 170A, and third dielectric layer 172A to provide an electrical interconnection with traces 129A and contacts 128.

Contacts 128 within first multi-level RDL 162 may be patterned ends 125 of capacitor structures 132a, 132b, 132c, 132f, 132g, as well as ends 127 vias 123, 124 and 126. Contacts 128 of second multi-level RDL 176 may similarly be patterned ends of capacitor structures 132d, 132e, as well as vias 123, 124, and 126.

In this example, main core body 108 may form 90% of the overall thickness T of the package substrate. The top or first multi-level RDL may form 5% of the thickness of the main body 108 and the second multi-level RDL at bottom surface 122 of the core body 108 may be 5% of the thickness of the main body 108. In other examples, the main core body 108 may have a thickness that is at least 50% or greater than the overall thickness of the package substrate, with the first and second multi-level RDLs each forming the remaining percentage of the overall package. In such example, which further includes two multi-level RDLS, the first and second multi-level RDLs may each be 25% percentage of the thickness of the overall package, or they may differ with either the first or second multi-level RDL having different thicknesses. In still other examples, there may be only one multi-level RDL in the package. In other examples, main core body 108 may form 50% of the overall thickness T. In still other examples, main core body 108 may form 60%, 70%, or 80% of the overall thickness T. In still other examples, main core body 108 may form less than 50% of the overall thickness of the package substrate.

The overall structure of the package substrate provides an improvement over conventional substrate processing which requires the use of an intermediate interposer or carrier to provide an interconnection between the chips and the package substrate. Because the ceramic substrate is highly smooth and planar, this allows for the application of the RDL directly to the top and/or bottom surfaces of the ceramic core body. As a result, RDL with fine traces is made possible. For example, traces can be spaced closely together, such that the space or gap G (FIG. 3) between two directly adjacent traces or a trace and another structure in the package substrate can be minimal. In one example, a minimum gap G between a metal trace and another metal element in the RDL layer may be less than 5 microns, less than 4 microns, or less than 2 microns, etc.

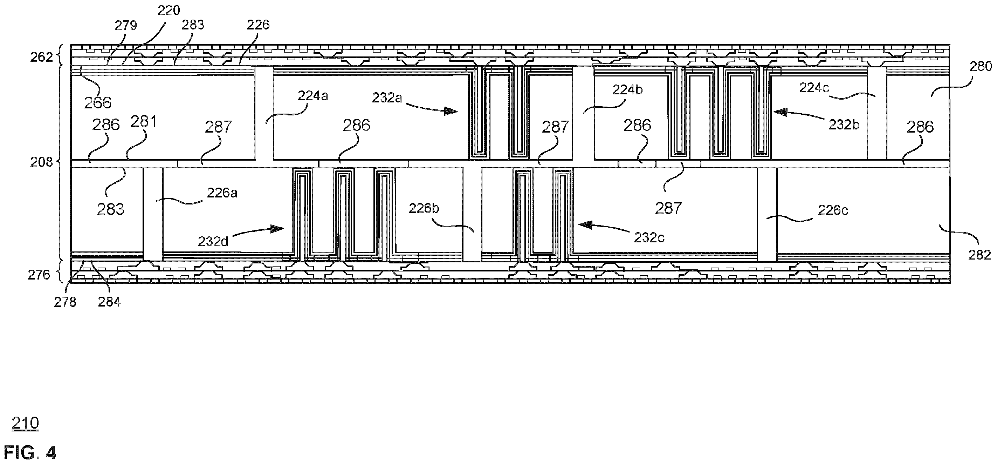

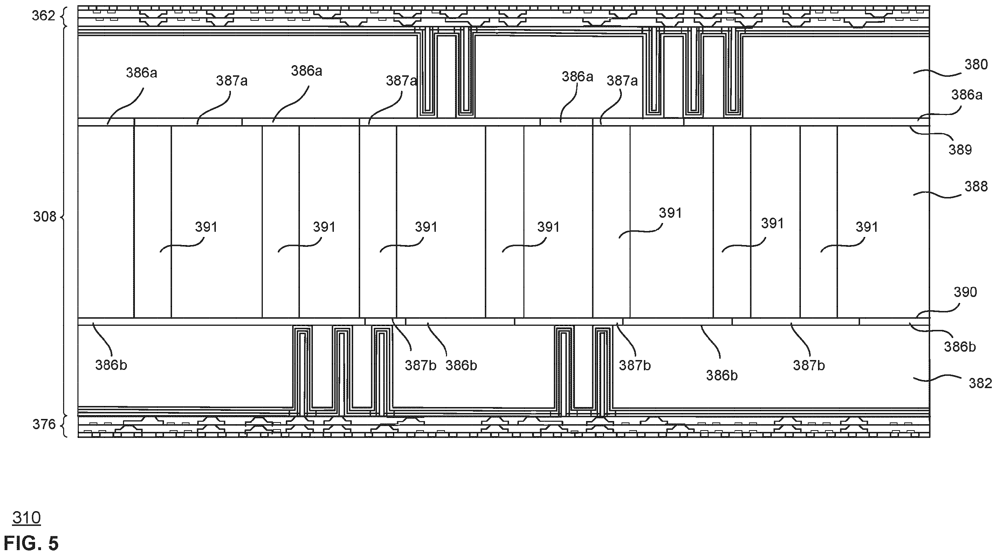

FIGS. 4 and 5 illustrate additional examples of ceramic package substrates, where two or more discrete ceramic sheets are joined together to form a package substrate, with at least one of the discrete ceramic sheets having embedded capacitors. Referring first to FIG. 4, a package substrate 210 is illustrated, which can be used in connection with a chip package assembly, including but not limited to chip package assembly 100 shown in FIG. 1. As in the example shown in FIGS. 2-3, package substrate 210 includes ceramic core body 208, first RDL 262 and second RDL 276. Package substrate 210 differs from package substrate 110 of FIG. 1 to the extent that core body 208 is comprised of more than one sheet of material, and in this example two ceramic sheets that are joined together to form main core body 208. As shown, core body 208 includes first ceramic sheet 280 and second ceramic sheet 282. First ceramic sheet 280 may include embedded capacitor structures 232a, 232b. Second ceramic sheet 282 may similarly include capacitor structures 232c, 232d that are also embedded. Upper vias 224a, 224b, 224c extend through top surface 279 and bottom surface 281 of first ceramic sheet 280. Lower vias 226a, 226b, 226c extend through top surface 283 and bottom surface 282 of second ceramic sheet 280.

First ceramic sheet 280 and second ceramic sheet 282 may be joined together to form main core body 208. In this example, first ceramic sheet 280 and second ceramic sheet 282 may be mechanically bonded together by a bonding layer. Bonding layer 286 may include a bonding material, such as an adhesive material, including thermal interface material (TIM). Bonding layer 286 may join bottom surface 281 of first ceramic sheet 280 to top surface 283 of second ceramic sheet 282. In other examples, intermediate inorganic layers may be used in place of bonding layer 286 and the first and second ceramic sheets 280, 282 may be sintered together. Similarly, first and second ceramic sheets 280, 282 may be directly bonded to one another without an intermediate material by fusing bottom surface 281 of first ceramic sheet 280 with top surface 283 of second ceramic sheet 282.

A conductive routing layer 287a, 287b, 287c may also be provided between the first and second ceramic sheets 280, 282. Conductive routing can allow for an electrical interconnection between the first and second ceramic sheets 280, 282. For example, conductive routing 287a, 287b, and 287c may provide interconnection with vias 224a, 224b, 224c and capacitor structures 232a, 232b in first ceramic layer 280 with one or more components in second ceramic layer 282, such as vias 226a, 226b, 226c and capacitor structures 232c and 232d.

As in the previous examples, redistribution layers may be applied directly to the top and bottom surfaces of core main body without an intermediate carrier structure. Bottom surface 266 of first redistribution layer 262 may be directly provided onto top surface 279 of first ceramic sheet 280, which is also top surface 220 of core body 208. Top surface 278 of second redistribution layer 276 may be directly provided on bottom surface 284 of second ceramic sheet 282. First and second redistribution layers 262, 276 may otherwise be identical to first and second multi-level RDLs 162, 176 discussed previously and are not further discussed here for brevity and ease of discussion.

The preceding discussions provide one example structural arrangement for first ceramic sheet 280 and second ceramic sheet 282. In other examples, first ceramic sheet 280 and/or second ceramic sheet 282 may differ in structural arrangement and any number and combination of vias and capacitor structures, as well as types of vias and capacitor structures, may be incorporated therein. Further, although both first and second ceramic sheets 280, 282 are shown as having capacitor structures therein, only one of the first and second ceramic sheets 280, 282 requires the presence of a capacitor structure.

FIG. 5 illustrates another example of a substrate that can be utilized in connection with chip packaging. Package substrate 310 includes a core body 308, a first redistribution layer 362, and a second redistribution layer 376. Core body 308 is composed of at least a ceramic material and includes a first ceramic sheet 380 and a second ceramic sheet 382. First and second ceramic sheets 380, 382 are structurally identical to first and second ceramic sheets 280, 282 in FIG. 4 and are not discussed again in detail for brevity and ease of discussion. Similarly, first and second redistribution layers 362, 376 may be structurally identical to first and second redistribution layers 262, 276 and are also not discussed again in detail for brevity and ease of discussion. In other examples, first ceramic sheet 380 and/or second ceramic sheet 382 may differ in the arrangement and any number and combination of vias and capacitor structures, as well as types of vias and capacitor structures, may be incorporated therein. Further, although both first and second ceramic sheets 380, 382 are shown as having capacitor structures therein, only one of the first and second ceramic sheets 380, 382 requires the presence of a capacitor structure.

Package substrate 310 differs from the prior example substrate 210 by the addition of an intermediate sheet 388 between the first and second ceramic sheets 380, 382 having through vias 391, as well as second bonding layer 386b between intermediate sheet 388 and second ceramic sheet 382 and second conductive routing layer 387b. In some examples, it may be desired to use an intermediate sheet 388 in order to increase overall thickness of core body 308 to provide added mechanical strength to package substrate 310. As shown, intermediate sheet 388 may be a planar structure having a top surface 389 and a bottom surface 390. Vias 391 may extend through top surface 389 and bottom surface 390 of intermediate sheet 388 to provide an electrical interconnection between first and second ceramic sheets 380, 382, as well as first and second redistribution layers 362, 376. While first and second sheets 380, 382 may be composed of non-organic material, such as ceramic, in some examples, intermediate sheet 388 may be composed of a material that is different from first and second ceramic sheets 380, 382. For example, intermediate sheet 388 may be composed of an organic material, including but not limited to organic resin and epoxy resin. In other examples, intermediate sheet 388 may be formed of a same or similar material as first and second ceramic sheets 388.

First adhesive layer 386a bonds first ceramic sheet 380 to intermediate sheet 388 and second adhesive layer 386b may bond second ceramic sheet 382 to intermediate sheet 388. Both first adhesive layer 386a and second adhesive layer 386b may be identical to adhesive layer 286 of FIG. 4 and are not discussed again for brevity and ease of discussion. Additionally, conductive routing layers 387a, 387b may conductively connect first and second conductive sheets together through vias 391, as well as first and second redistribution layers 362, 376. Vias 391 within intermediate layer 388 may be formed using conventional techniques and may be openings filled with conductive material that extend through top surface 389 and bottom surface 390 of intermediate sheet 388. Although through vias are only shown within intermediate sheet 388, in other examples, through vias may also be incorporated into one or both of first and second ceramic sheets 380, 382, as previously disclosed herein.

Package substrates 210, 310 disclosed herein allow for separate processing of the first ceramic sheets 280, 380 and second ceramic sheets 380, 382, which collectively form the respective core bodies 208, 308. This can allow for ease of manufacturing by allowing for the manufacture of first and second ceramic sheets 280, 380, 282, 382 with through capacitive structures or structures that extend fully through top and bottom surfaces of the ceramic sheet, instead of a capacitor structure that extends only partially through the thickness of the sheet. Additionally, use of two or more ceramic sheets can improve the overall yield of package substrate.

Intermediate sheet 388 as shown provides one structural example of an intermediate sheet that can be provided between first and second ceramic sheets 380, 382. In other examples, intermediate sheet 388 may include additional conductive elements, a greater or fewer number of vias 391. Similarly, intermediate sheet 388 may instead be formed from an inorganic material or may be a composite sheet that includes both organic and inorganic materials.

In other examples, instead of or in addition to one or more of the redistribution layers being built up on intermediate sheet 388 and core body 308, one or more organic dielectric layers may be lamination bonded to core body 308 and metal may be plated or etched to form conductive connections.

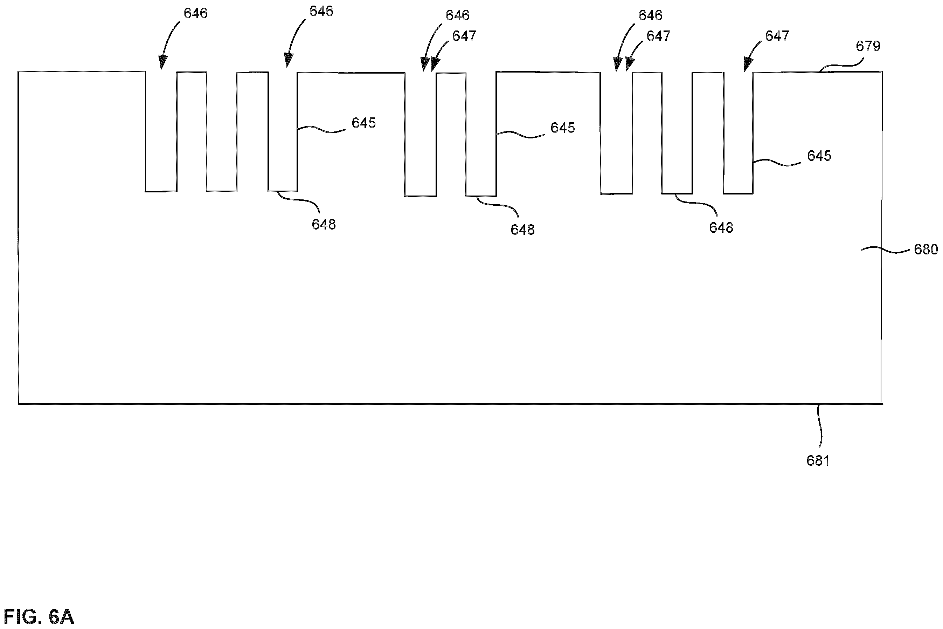

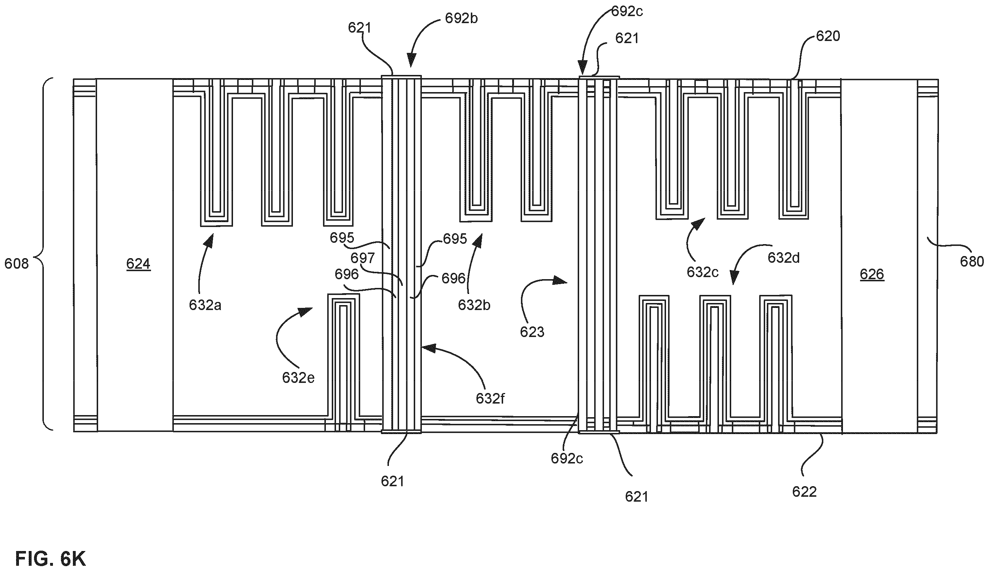

FIGS. 6A-6R illustrate an example method for manufacturing a package substrate, such as package substrate 110. As shown in FIG. 6A, a primary portion of core body 608 (FIG. 6K) is formed from a ceramic sheet 680 that includes top surface 679 and bottom surface 681. Ceramic sheet 680 may be comprised of ceramic materials as disclosed herein. To form embedded capacitor structures, openings 646 may be created in ceramic sheet 680 using known methods. In one example, openings 646 may be formed by etching or drilling through ceramic sheet 680. Openings 646 may extend partially through the ceramic sheet 680 and include an interior surface 645. Entrances 647 to openings 646 are at or adjacent top surface 679 of ceramic sheet 680. Bottom surfaces 648 of openings 646 are spaced away from bottom surface 681 of ceramic sheet 680. Openings 646 can be designed to form branches or arms of capacitor structures, such as to form the shape of a "U" (two branches) or an "E" (three branches).

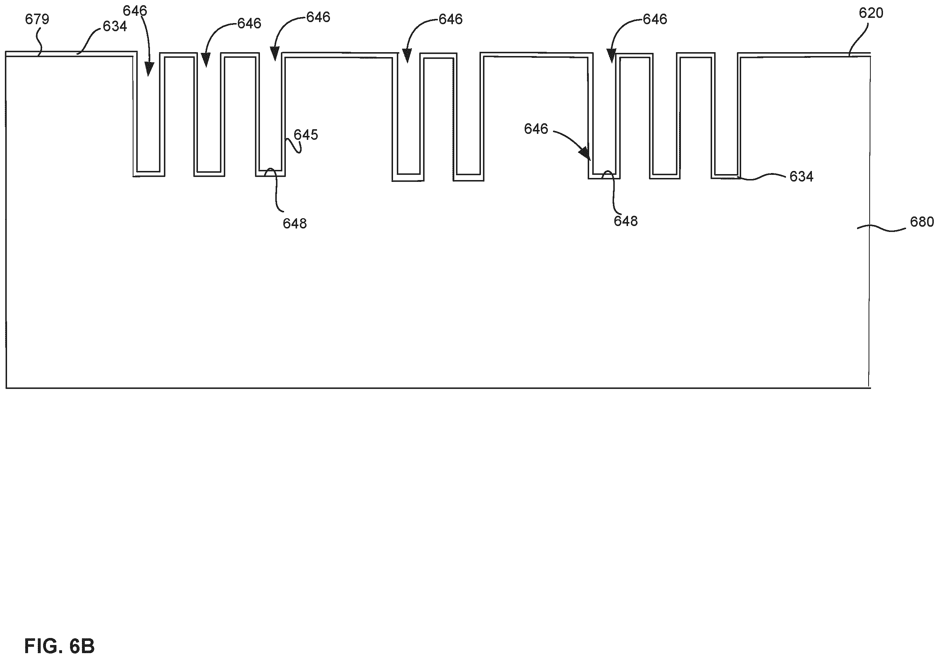

Openings 646 may be processed with layers of material that will collectively form embedded capacitor structures. For example, as shown in FIG. 6B, a first insulating or dielectric layer 634 may be provided on top surface 679 of ceramic sheet 680 and within openings 646. First dielectric layer 634 may be deposited along and line interior surfaces 645 of each opening 646, including bottom surface 648 of opening 646. The dielectric material composing dielectric layer 634 may be any dielectric material, such as aluminum oxide or polyimide.

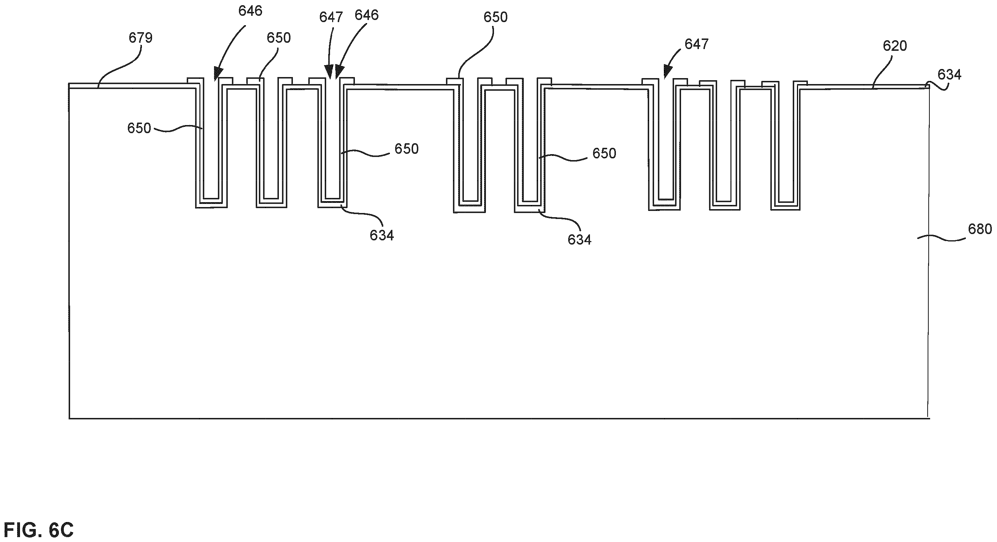

As shown in FIG. 6C, a second conductive layer 650 may be deposited on top of dielectric layer 634 using known conventional methods. Second conductive layer 650 may be a conductive metal layer that overlies dielectric layer 634 and extends into each of openings 646. In one example, second conductive layer 650 is formed from copper, but any other metal, alloy, combination, or other conductive material may be used. Second conductive layer 650 may initially be provided across some or all of first dielectric layer 634, which also overlies top surface 679 of ceramic sheet 680, as well as within openings 646. Conductive layer 650 may then be patterned to be part of the structure forming conductive contacts 628 that will be disposed at top surface 620 of main body 608.

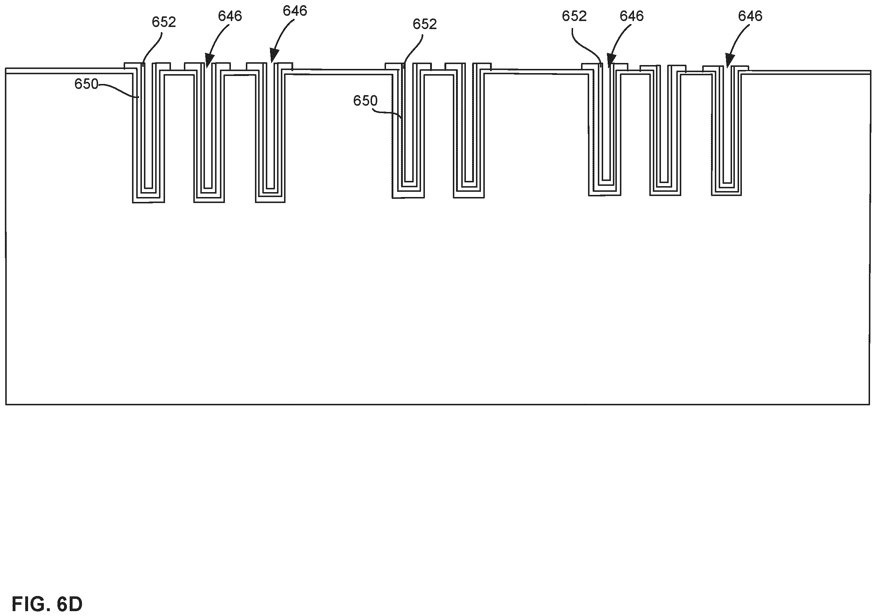

As shown in FIG. 6D, a third insulating or dielectric layer 652 may be deposited into each opening. Third insulating layer 652 may be a layer that overlies second conductive layer 650 and follows the shape of opening 646. Third dielectric layer 652 may be formed from a high-k dielectric material, including but not limited to those described herein, and will function as the capacitor dielectric.

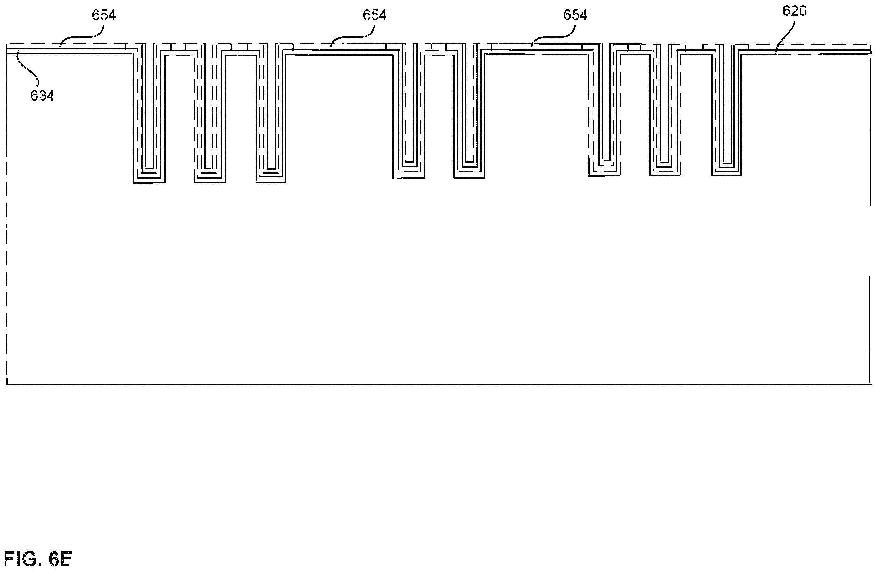

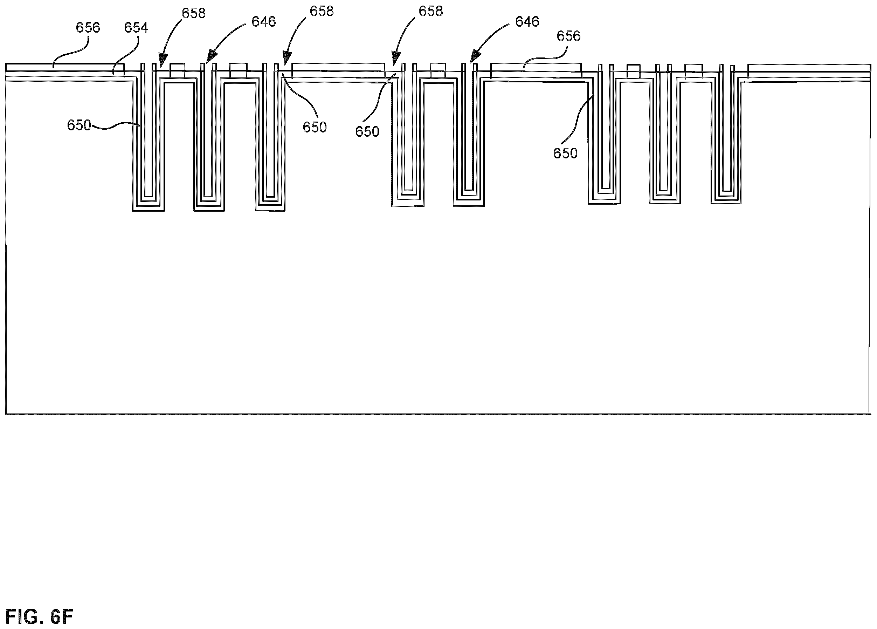

A fourth insulating or dielectric layer 654, shown in FIG. 6E, may be provided across top surface 679 of ceramic sheet 680 and overlie first dielectric layer 634. Optionally, fourth dielectric layer 654 may be polished. Deposition of fourth dielectric layer 654 will create a planar surface. A fifth insulating or dielectric layer 656 may be deposited on top of fourth dielectric layer 654, as shown in FIG. 6F and then patterned with openings 658 to expose the underlying patterned metallization from second conductive layer 650.

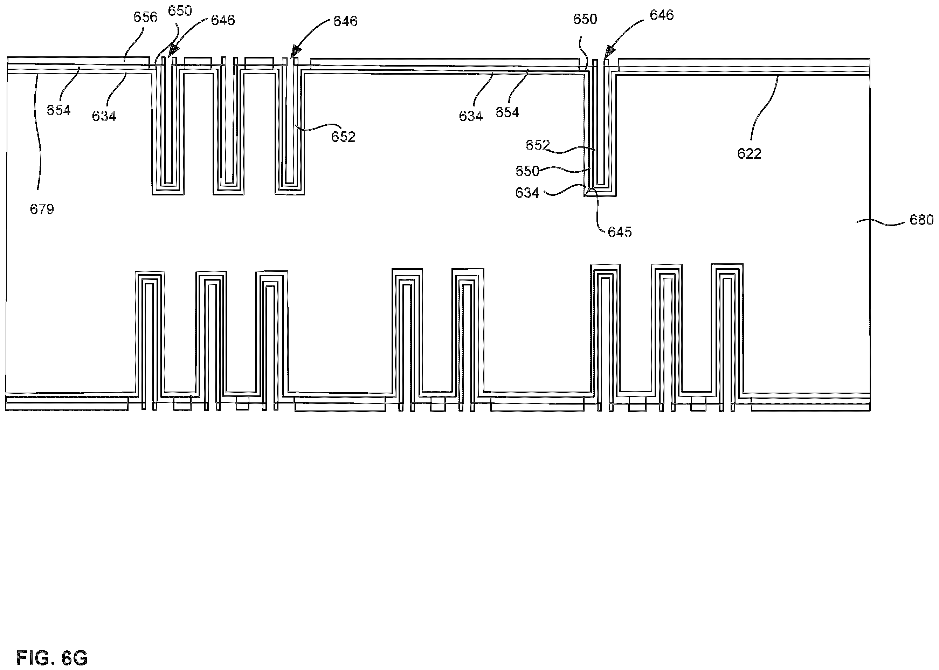

With reference to FIG. 6G, bottom surface 681 of ceramic sheet 680 may be similarly processed. For example, ceramic sheet 680 may be inverted to allow for processing of surface 681, as previously described with regard to processing of top surface 679 in FIGS. 6A-6F. Partial through openings 646 may first be created through bottom surface 681 and a first dielectric layer 634 may be deposited along and overlie bottom surface 681 and along each of the walls or interior surfaces 645 of openings 646. A second conductive layer 650 may be deposited within openings 646 and extend onto a portion of bottom surface 622. Second conductive layer 650 may be deposited on top of and overlie first dielectric layer 634 and extend into openings 646. Second conductive layer 650 may be patterned to form conductive connections, which will be formed as part of contacts 628. A third dielectric layer 652 may be provided within openings 646. As in the previous examples, third dielectric layer 652 may be comprised of a high-k dielectric material that will form the capacitor dielectric. A fourth insulating or dielectric layer 654 may be deposited adjacent and around portions of second conductive layer 650 that extend across bottom surface 622. Lastly, a fifth insulating or dielectric layer 656 may be deposited across fourth dielectric layer 654, and then etched to expose portions of conductive layer 650.

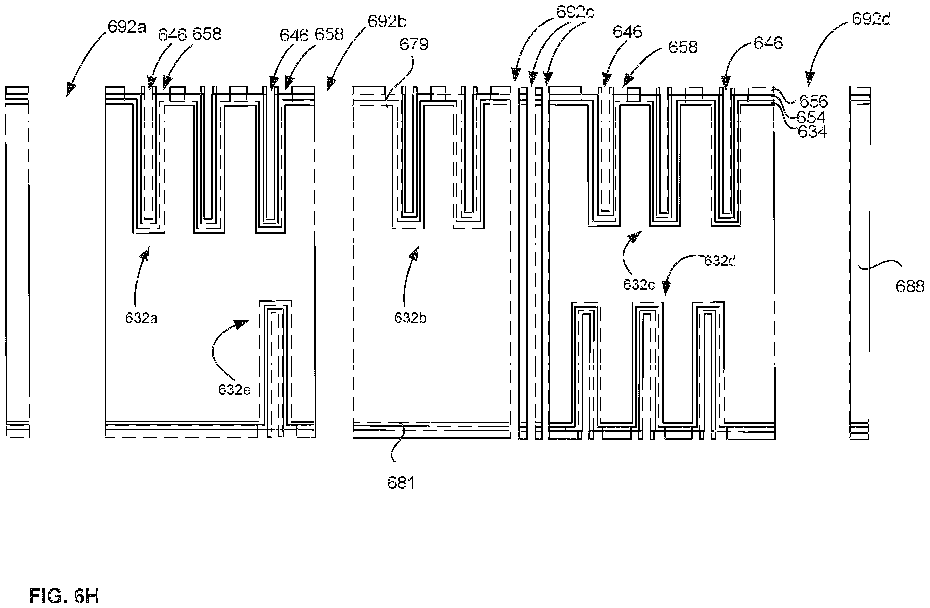

As shown in FIG. 6H, through openings may be created within ceramic sheet 680, as well as through dielectric and conductive layers overlying top and bottom surfaces 679, 681 of ceramic sheet 680. The openings may be used to form one or more through hole vias and/or one or more capacitor structures. For example, openings 692a, 692b, 692c, and 692d are example through openings that extend between and through top and bottom surfaces 679, 681 of ceramic sheet 680, as well as through first dielectric layer 634, fourth dielectric layer 654, and fifth dielectric layer 656, all of which overlie top and bottom surfaces 679, 681 of ceramic sheet 680. Openings 692a, 692b, 692c, and 692d that will be used to create through vias and through capacitors in this example are created after openings 646 for the other capacitor structures that extend partially through ceramic sheet 680 are created, as described in FIG. 6A, but in other examples, the through openings may be created at any desired time. For example, the through hole openings may be formed before or at the same time the openings 646 (FIG. 6A) for capacitor structures 632a-632e are created.

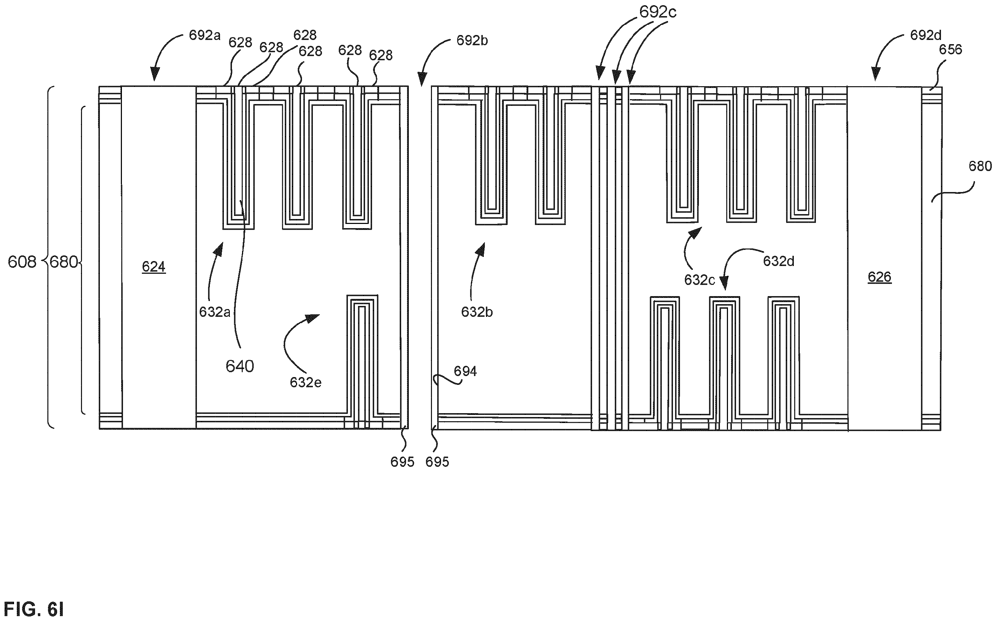

Once openings 692a, 692b, 629c, and 692d are created, further processing can create conductive elements, including contacts, one or more through vias, and/or one or more capacitor structures. For example, as shown in FIG. 6I, outermost openings 692a, 692d may be filled with a conductive material to form single hole through vias 624, 626. Similarly, the plurality of openings 692c may be filled with conductive material to form multi-hole through vias. Conductive material may also fill openings 658 (FIG. 6H) in fifth dielectric layer 656 that expose underlying conductive material, as well as openings 646 (FIG. 6H) in capacitor structures 632a, 632b, 632c, 632d, 632e that extend partially through ceramic sheet 680. For example, when opening 646 is filled with a conductive material, a conductive fill or layer 640 is formed. Similarly, when opening 658 is filled with conductive material, it forms part of conductive layer 656. The filled openings 646, 658 form conductive connections or contacts 628 that overlie top surface 620 of core body 608.

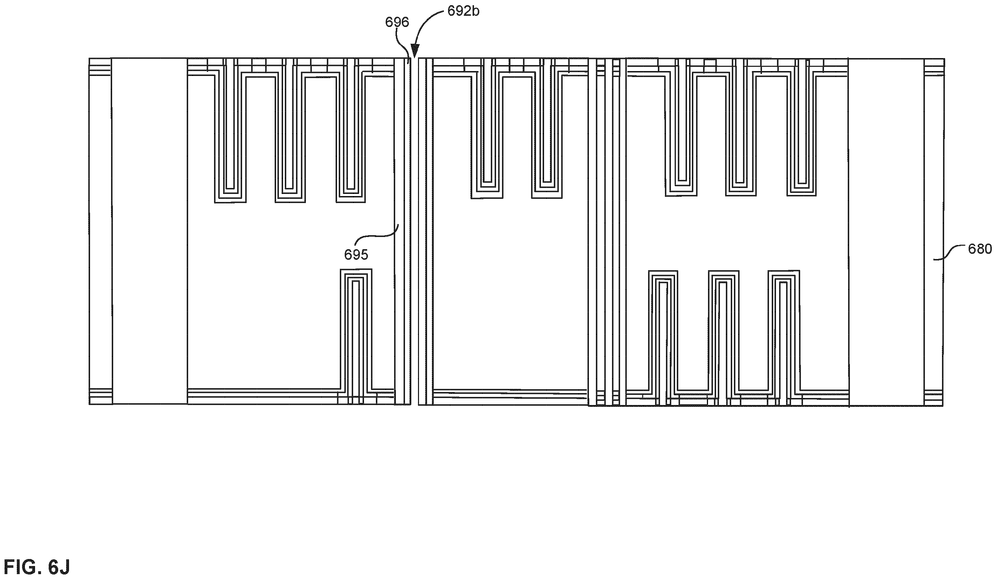

Opening 692b may be processed to create an alternative capacitor structure using a slightly different process. In one example, a first conductive layer 695 may be deposited within opening 692b and along interior surface 694 of opening 692b. A second dielectric layer 696, shown in FIG. 6J, may be deposited within opening 692b, as well as overlie first conductive layer 695. Lastly, as shown in FIG. 6K, a third conductive layer 697 may fill the remainder of the opening 692b that remains exposed when first dielectric layer 696 is deposited. This creates a plurality of capacitor structures where adjacent dielectric layers are separated by an intermediate dielectric layer.

To complete manufacture of the through capacitor structure 632f, second dielectric layer 696 may be deposited along first conductive layer 695 within opening 692b, as shown in FIG. 6K. Third or central conductive layer 697 may be deposited along second dielectric layer 696 to fill the remainder of opening 692b. With additional openings 692a, 692c, 692d and openings 646 being filled with conductive material, the final core body 608 is formed with embedded capacitors 632a, 632b, 632c, 632d, 632c, 632f, single hole through vias 624, 626, and multi-hole through via 623. Core body 608 includes a top surface 620 and a bottom surface 622. Conductive pads 621 may be patterned over capacitor structure 632f and through each opening 692c of multi-hole through via 623 or in other examples, may be patterned during manufacturing of capacitor structure 632f and via 623.

Once core body 608 is completed, RDL(s) may be built-up or processed directly onto core body 608 at either or both the top surface 620 and bottom surface 622. The stiffness and arrangement of components within ceramic core body 608 make it possible to build redistribution layers directly on top surface 620 of core body 608, instead of having to first prepare the RDL on a temporary carrier and then transfer the RDL to core body 608. Substrates formed according to conventional methods of substrate formation, such as laminated layers of organic material, cannot achieve the needed planarity that makes it possible to form RDL directly on ceramic core body 608 and/or make it possible to achieve fine routing.

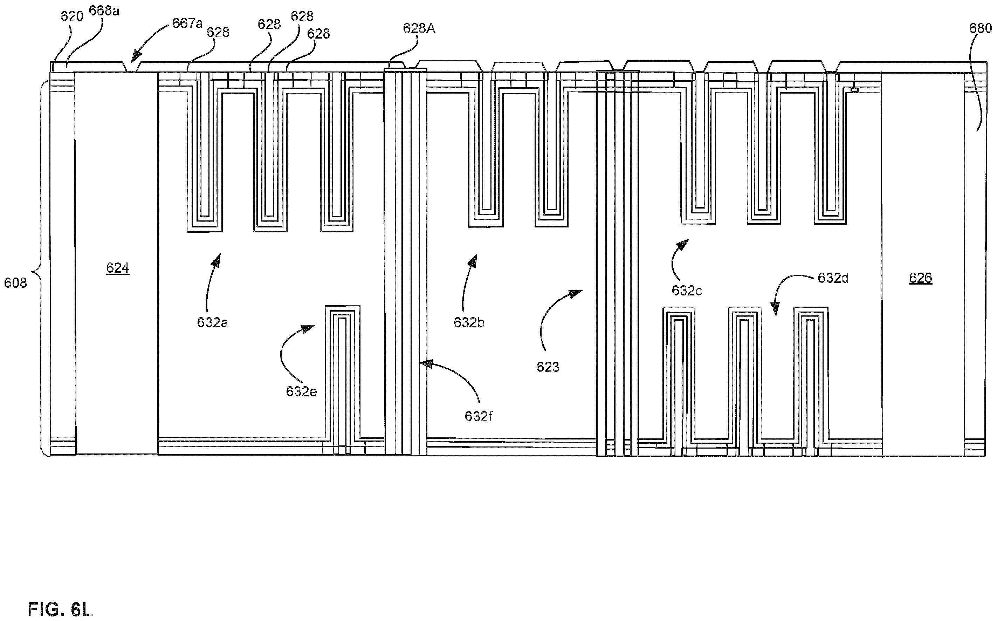

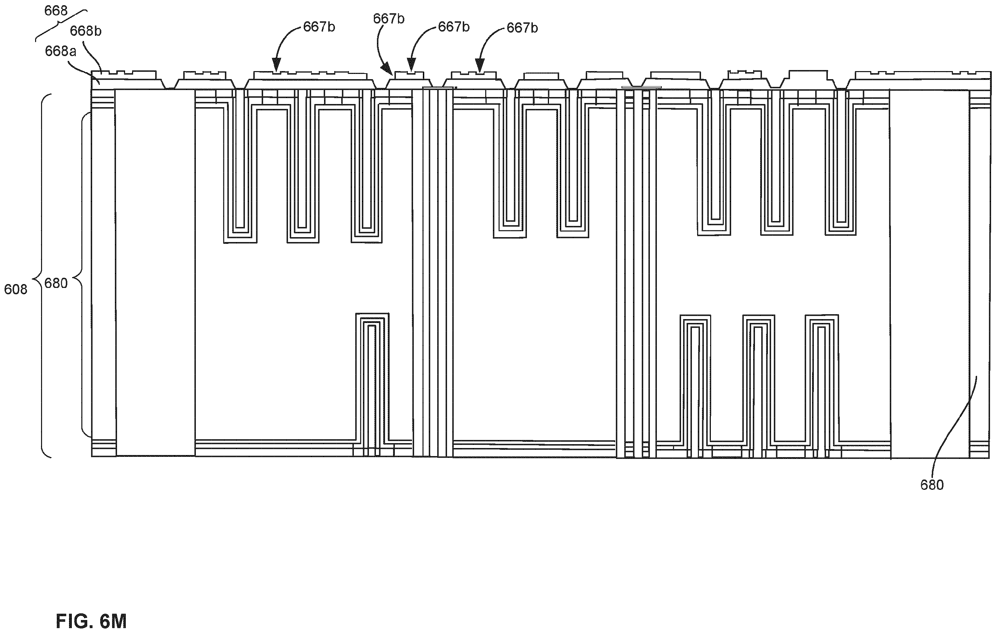

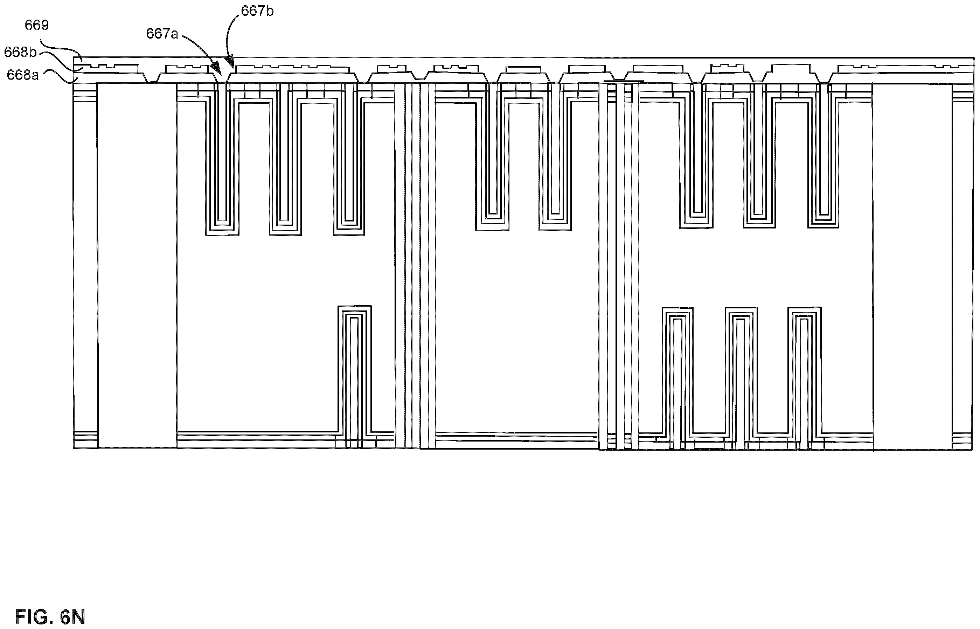

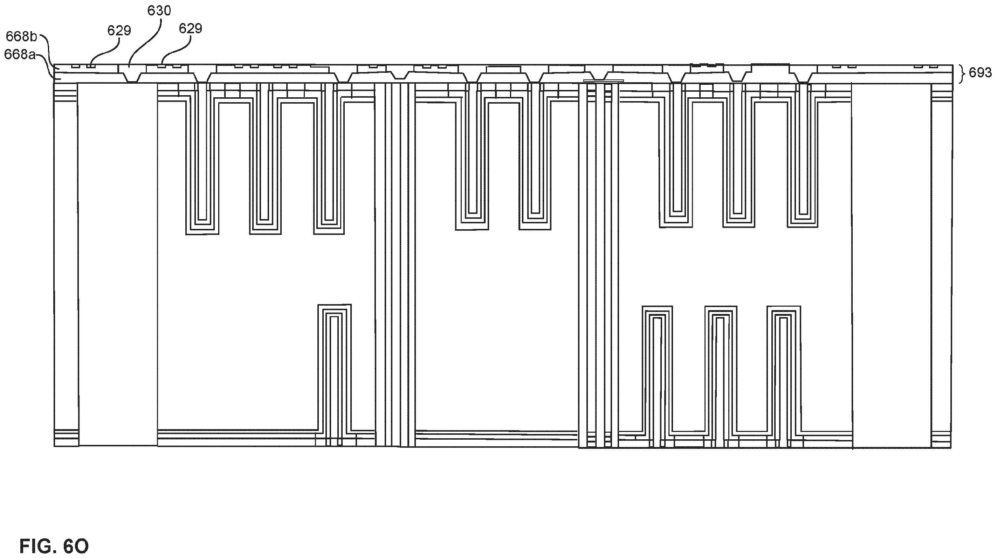

FIGS. 6L-6Q illustrate one example of the manufacture of a multi-level RDL directly on top surface 620 of core body 608. Turning first to FIG. 6L, first dielectric layer 668a may be deposited directly onto top surface 620 of core body 608 and patterned to form openings 667a that expose underlying portions of conductive material, such as through vias 624, 626, and 623 and contacts 628 of capacitors 632a, 632b, 632c. As shown in FIG. 6M, second dielectric layer 668b may be deposited over first dielectric layer 668a and in this example, first dielectric layer 668a and second dielectric layer 668b form first set of dielectric layers 668. Second dielectric layer may be patterned to create additional openings 667b that can be used to form routing for traces and conductive vias within an RDL. A thin seed layer (not shown) can optionally be deposited over second dielectric layer 668b, and then as shown in FIG. 6N, a first metal layer 669 may be deposited over first and second dielectric layers 668a, 668b and within openings 667a, 667b. Portions of first metal layer 669 may then be etched or removed so that only conductive material within openings 667a, 667b remain, as shown in FIG. 6O. The filled openings create traces 629 and conductive vias 630 and otherwise form a first level 693 of what will become a multi-level RDL .

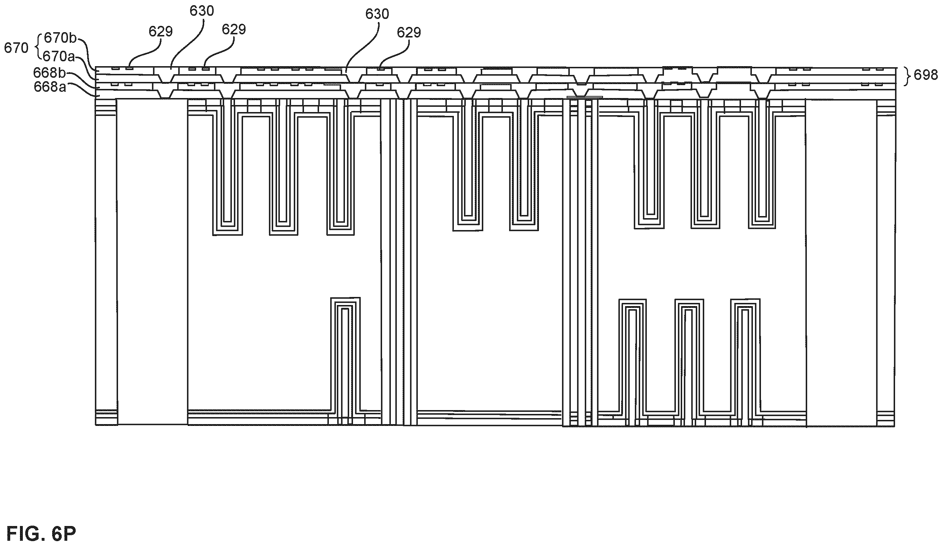

As shown in FIG. 6P, steps 6L-6O can be repeated to build-up a second level 698 of what will become a multi-level RDL 662. For example, a second set of dielectric layers 670 can include a third dielectric layer 670a and a fourth dielectric layer 670b. Third dielectric layer 670a can be directly deposited and built onto second dielectric layers 668b. Third dielectric layer 670a may be further patterned to include openings. Fourth dielectric layer 670b may be deposited and built directly on top of third dielectric layer 670a and patterned to also include openings. A seed layer may then be deposited within openings in the third and fourth dielectric layers 670a, 670b to form additional conductive traces 629 and vias 630.

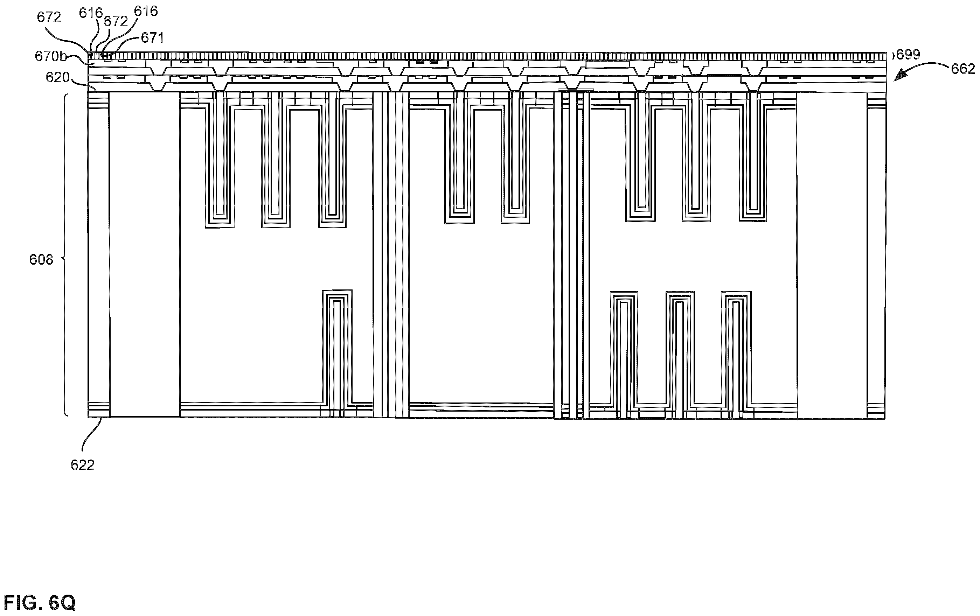

Lastly, as shown in FIG. 6Q, a third level 699 of multi-level RDL 662 is built-up directly onto core body. Fifth dielectric layer 672 may be deposited on top of fourth dielectric layer 670b and patterned to include openings 671. A seed layer (not shown) may be deposited across rear surface and within openings 671. As previously described, a metal layer may be deposited into openings 671 and excess metal and seed layer may be etched to leave behind a plurality of terminals 616. The first multi-level RDL 662 is complete with the formation of terminals 616.

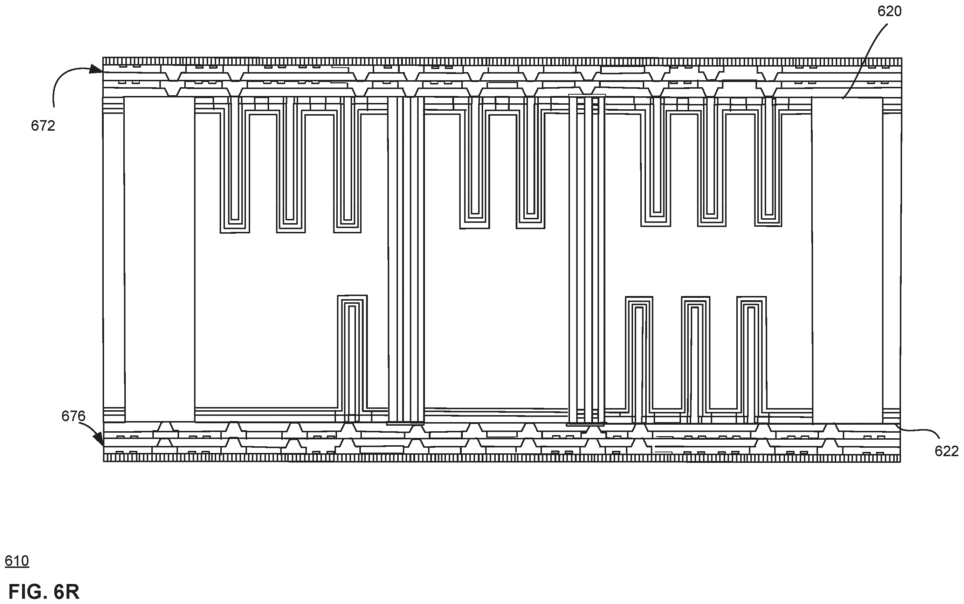

The same process may be implemented to provide a second multi-level RDL 676 on bottom surface 622 of core body 608, as shown in FIG. 6R. The same or similar processes shown in FIGS. 6A-6Q can be performed directly on bottom surface 622 of core body 608 to allow a second multi-level RDL 676 to be built-up directly onto core body 608.

It is to be appreciated that FIGS. 6A-6R provide one example method of forming a package substrate according to aspects of the disclosure and in this example, package substrate 610. There are numerous other ways in which to manufacture package substrate 610. For example, RDL layers may instead be a single level or single layer RDL, instead of a multi-level RDL. The multi-level RDL may have more than two levels or sets of dielectric layers or more than three levels or sets of dielectric layers. The first multi-level RDL may differ from the second multi-level RDL or there may be only one RDL in the package substrate altogether. Furthermore, although the method of forming package substrate was described in a certain order, the order of steps can vary, as needed. For example, it may be desired to create all openings in the ceramic sheet at one time and/or to create redistribution layers at the top and bottom surface at the same time. Similarly, it may desired to only form embedded capacitors adjacent one surface, such that it is not necessary to process both surfaces of the core body.

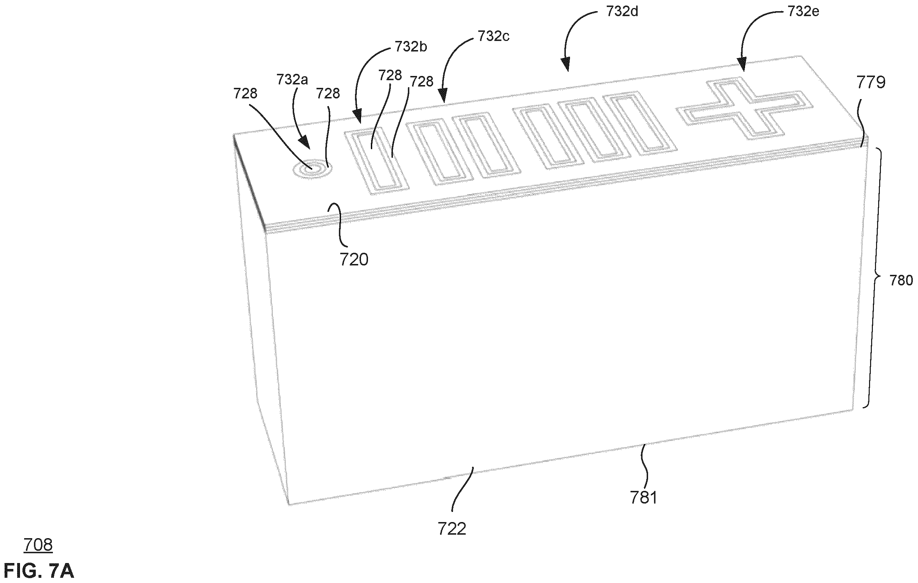

The shape of capacitor openings may also vary. As noted above, the shape of capacitor structures disclosed, including their cross-sections, can vary widely. Some examples include circular, rectangular, cross-shaped, E-shaped, W-shaped, and the like. FIG. 7A illustrates core body 708 with capacitor structures 732a, 732b, 732c, 732d, and 732e that have different shaped cross-sectional openings. Core body 708 does not further include through-vias or through capacitor structures on both top and bottom surface of core body 708, but any additional structures can be implemented within core body 708. Core body 708 includes a top surface, a bottom surface, and capacitor structures 732a, 732b, 732c, 732d, and 732e embedded therein. Core body 708 further includes a ceramic sheet 780 having top surface 779 and bottom surface 781, with additional dielectric and conductive layers that form capacitor structures 732a, 732b, 732c, 732d, and 732e and that overlie top surface 779 of ceramic sheet 780. The capacitor structures can take on numerous configurations and shapes. As shown, in this example, core body 708 includes a circular capacitor structure 732a, an I-shaped capacitor structure 732b, a U-shaped capacitor structure 732c, an E- or W-shaped capacitor structure 732d, and a cross-shaped or plus sign shaped capacitor 732e, all of which are embedded within core body 708. Contacts 728 may be exposed at top surface 720 of core body 708.

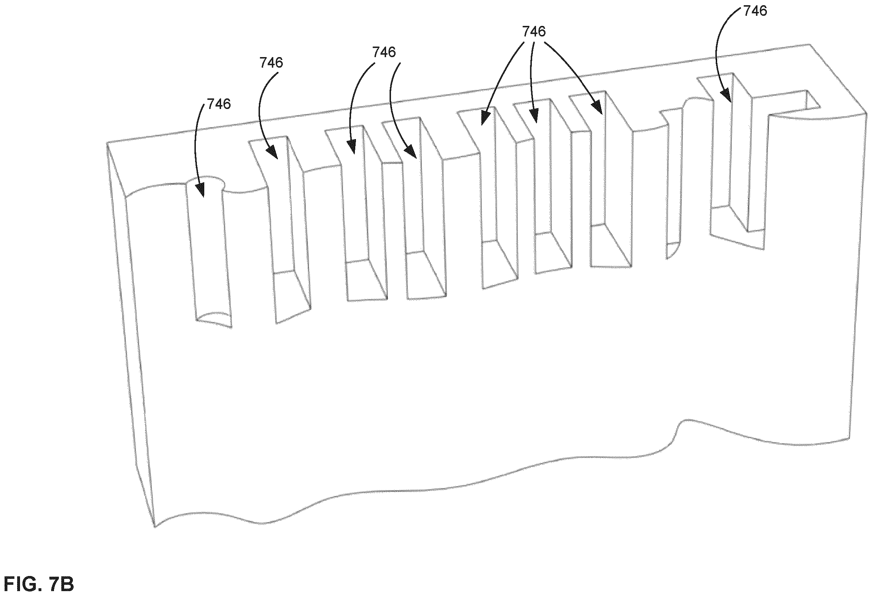

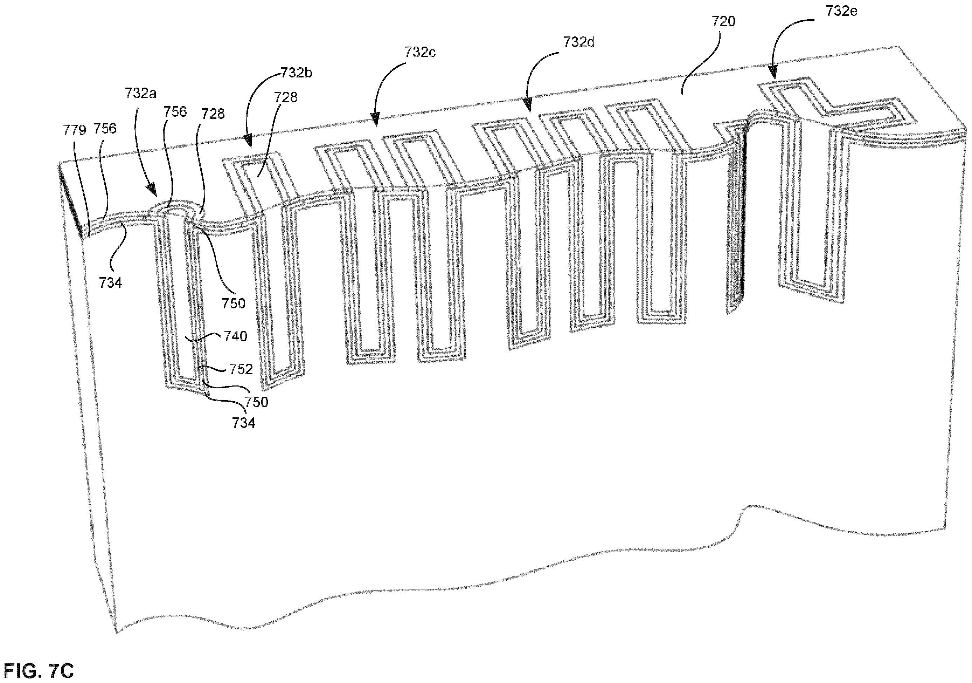

Capacitor structures 732a, 732b, 732c, 732d, 732e may be manufactured within core body 708 similar to the methods of manufacture used to create capacitor structures previously described herein, although any methods of manufacture can be implemented. FIG. 7B illustrates a cross-sectional view of a bare ceramic sheet 780 with openings 746 extending partially through core body 708 that will be processed to form capacitor structures 732a, 732b, 732c, 732d, 732e. As shown in FIG. 7C, each of the openings may be filled with conductive and dielectric layers to form capacitor structures. A first dielectric layer 734 overlies top surface 779 of ceramic sheet 788 and extends through each opening 746. A second conductive layer 750 may be deposited within each opening, as well as directly adjacent to each opening to help form the structure that will form contacts 728. A third dielectric layer 752 may be deposited within opening 746 and line interior opening and the second conductive layer 750 within opening 746. A fourth dielectric layer may be positioned adjacent and around portions of second conductive layer 750 that overlie top surface 779 of core body 708. A fifth dielectric layer 756 overlies fourth dielectric opening and is patterned with openings to expose portions of second conductive layer 750. A conductive material then fills each of the openings at top surface of overall core body 708 to form contacts 728, as well as a central conductive layer 740 within remaining openings in each capacitor structure.

According to an aspect of the disclosure, a package substrate for a microelectronic package assembly includes an inorganic core body having a top surface and a bottom surface; at least one core via extending through the top and bottom surfaces of the core body; at least one built-up redistribution layer built up on one of the top surface or the bottom surface of the inorganic core body, and at least one capacitor structure embedded within the inorganic core body and extending between the top and bottom surfaces of the inorganic core body. The redistribution layer may include at least one dielectric layer, a plurality of conductive traces and contacts overlying the at least one dielectric layer, and redistribution vias extending through the at least one dielectric layer. The at least one capacitor structure may further include at least two conductive layers and a capacitor dielectric layer disposed between the at least two conductive layers. The at least one core via may conductively connect first terminals disposed at a top surface of the substrate with second terminals disposed at a bottom surface of the substrate; and/or
the inorganic core body may further include a ceramic material; and/or
the ceramic material may be comprised substantially of one of the following materials: aluminum oxide (Al2O3), aluminum nitride (AlN), silicon nitride (Si3N4), silicon carbide (SiC) and zirconia oxide (ZrO2); and/or
the at least one capacitor structure has a length extending between the top and bottom surfaces of the core body that is at least 5% of a total length of the core body, and the total length is a length between the top surface and the bottom surface of the core body; and/or
the dielectric layer comprises a dielectric material, the dielectric material comprising an inorganic material; and/or
the dielectric layer comprises a dielectric material, the dielectric material comprising an organic material; and/or
a minimum width of at least some of the plurality of conductive traces is less than 5µm; and/or
a minimum width of at least one conductive trace of the plurality of conductive traces is less than 2µm; and/or
a minimum gap between at least one conductive trace of the plurality of conductive traces and another conductive element along a same plane is less than 5µm; and/or
the minimum gap between at least one conductive trace of the plurality of conductive traces and another conductive element disposed along a same plane is less than 2µm; and/or
at least one conductive layer of the at least two conductive layers of the capacitor structure has a length extending in a direction between the top and bottom surfaces of the core body that is at least 10 times a thickness of the at least one conductive layer that extends in a direction perpendicular to its length; and/or
the dielectric capacitor layer comprises a dielectric constant greater than 5; and/or
terminals of the capacitor structure are disposed at the top and bottom surfaces of the core body.

According to another aspect of the disclosure, a microelectronic package assembly includes a package substrate; and at least one integrated circuit chip bonded to the substrate. The at least one integrated circuit chip is conductively connected to at least one of the conductive traces disposed at the substrate. The package substrate further includes an inorganic core body having a top surface and a bottom surface; at least one core via extending through the top and bottom surfaces of the core body; at least one built-up redistribution layer built up on one of the top surface or the bottom surface of the inorganic core body, and at least one capacitor structure embedded within the inorganic core body and extending between the top and bottom surfaces of the inorganic core body. The redistribution layer may include at least one dielectric layer, a plurality of conductive traces and contacts overlying the at least one dielectric layer, and redistribution vias extending through the at least one dielectric layer. The at least one capacitor structure may further include at least two conductive layers and a capacitor dielectric layer disposed between the at least two conductive layers. The at least one core via may conductively connect first terminals disposed at a top surface of the substrate with second terminals disposed at a bottom surface of the substrate; and/or
at least one electrical interconnect is disposed at a top surface or a bottom surface of the package substrate; and/or
the electrical interconnect comprises a solder ball; and/or
the at least one integrated circuit chip is one of a central processing unit chip, a graphics processing unit chip, a field programmable gate array chip and an application-specific integrated circuit (ASIC) chip; and/or
the at least one integrated circuit chip is an ASIC; and/or
the ASIC is a tensor processing unit chip; and/or
the at least one integrated circuit chip is a first chip, and the assembly further comprises a second plurality of integrated circuit chips stacked one on top of the other and conductively connected to the first chip through the package substrate; and/or the inorganic core body may further include a ceramic material; and/or
the ceramic material may be comprised substantially of one of the following materials: aluminum oxide (Al2O3), aluminum nitride (AlN), silicon nitride (Si3N4), silicon carbide (SiC), and zirconia oxide (ZrO2); and/or
   the at least one capacitor structure has a length extending between the top and bottom surfaces of the core body that is at least 5% of a total length of the core body, and the total length is a length between the top surface and the bottom surface of the core body; and/or
the dielectric layer comprises a dielectric material, the dielectric material comprising an inorganic material; and/or
the dielectric layer comprises a dielectric material, the dielectric material comprising an organic material; and/or
a minimum width of at least some of the plurality of conductive traces is less than 5µm; and/or
a minimum width of at least one conductive trace of the plurality of conductive traces is less than 2µm; and/or
a minimum gap between at least one conductive trace of the plurality of conductive traces and another conductive element along a same plane is less than 5µm; and/or
the minimum gap between at least one conductive trace of the plurality of conductive traces and another conductive element disposed along a same plane is less than 2µm; and/or
at least one conductive layer of the at least two conductive layers of the capacitor structure has a length extending in a direction between the top and bottom surfaces of the core body that is at least 10 times a thickness of the at least one conductive layer that extends in a direction perpendicular to its length; and/or

the dielectric capacitor layer comprises a dielectric constant greater than 5; and/or
terminals of the capacitor structure are disposed at the top and bottom surfaces of the core body.

According to still another aspect of the disclosure, a method of manufacturing a package substrate for a chip package assembly includes forming one or more capacitor structures within an inorganic core body; forming a conductive through-via within one of the plurality of openings that extends through the top surface and bottom surface of the core body; and building a redistribution layer directly onto the inorganic core body. The forming one or more capacitor structures within an inorganic core body may further include depositing a first conductive layer along an interior surface of a plurality of openings within the core body; depositing a second dielectric layer within the plurality of openings, the dielectric layer overlying the first conductive layer, the dielectric layer comprising a dielectric material having a high dielectric constant; and filling a remainder of the plurality of openings with a third conductive layer, such that the third conductive layer is insulated from the first conductive layer by the second dielectric layer. The building a redistribution layer directly onto the inorganic core body may further include depositing a dielectric layer directly onto the core body; patterning the dielectric layer to form a plurality of openings; and filling the openings with conductive material to form conductive interconnections; and/or
the patterning further includes forming some of the plurality of openings into a trace pattern, and filling the openings includes filling the some of the plurality openings with conductive material to form conductive traces; and/or
the patterning further includes forming other of the plurality of openings into through via openings that extend between top and bottom surfaces of the dielectric layer, and filling the openings includes filling the other of the plurality of openings with conductive material to form conductive vias; and/or
the patterning further includes forming other of the plurality of openings into via openings that extend between top and bottom surfaces of the dielectric layer, and filling the openings includes filling the via openings with conductive material to form terminals of the package substrate; and/or
depositing a dielectric layer is depositing a first dielectric layer, and the method further includes depositing a second dielectric layer directly onto the first dielectric layer; patterning the dielectric layer to form a second plurality of via openings and a second plurality of trace openings; and filling the second plurality of via openings and the second plurality of trace openings with conductive material so as to respectively form conductive vias and conductive traces; and/or
the depositing a dielectric layer is depositing a first dielectric layer, and the method further comprises depositing a second dielectric layer overlying the first dielectric layer; patterning the second dielectric layer to form a second plurality of via openings; and filling the second plurality of via openings with conductive material so as to form conductive vias, at least some of the vias forming terminals of the package substrate.

According to yet another aspect of the disclosure, a package substrate for a microelectronic package assembly includes an inorganic core body having a top surface and an opposed bottom surface, a first built-up redistribution layer comprising at least one dielectric layer and at least one conductive component disposed within the at least one dielectric layer, and a second built-up redistribution layer directly built up onto the second surface of the core body. The core body may further include a first inorganic sheet having a top surface and an opposed bottom surface. The first inorganic sheet may further include at least one first sheet via extending through the top and bottom surfaces; and at least one capacitor structure having a total length extending between the top and bottom surfaces of the first organic sheet. The total length may be at least 5% of a total length of the first inorganic sheet between the top surface and the bottom surface of the first inorganic sheet. The second inorganic sheet may have a top surface and an opposed bottom surface. The second inorganic sheet may be joined to the first inorganic sheet and include at least one second sheet via extending through the top and bottom surfaces of the second inorganic sheet. The at least one dielectric layer and the at least one conductive component manufactured being built up onto the first surface of the core body; and/or
the at least one capacitor structure extends through a thickness of the first inorganic sheet, the thickness extending in a direction between the top and bottom surfaces of the first inorganic sheet; and/or
capacitor terminals are disposed at at least one of the top surface and the bottom surface of the first inorganic sheet; and/or
at least one second capacitor structure is embedded within the second inorganic sheet; and/or
the core body further includes a bonding layer joining the first inorganic sheet to the second inorganic sheet, the first and second inorganic sheets being electrically connected to at least one electrically conductive element disposed between the first and second inorganic sheets and having at least one layer of conductive traces disposed at at least one of the top surface or the bottom surface of the second inorganic sheet; and/or
the bonding layer comprises an organic material; and/or
the bonding layer comprises an inorganic material; and/or
the core body further comprises a fused dielectric material fusing the first inorganic sheet and the second inorganic sheet together; and/or
dielectric material is Silicon Oxide (SiO2) or Silicon Nitride (SiN) ; and/or
the at least one dielectric layer is an at least one first dielectric layer, the at least one conductive component is an at least one first conductive component, and the second built-up redistribution layer further includes at least one second dielectric layer and at least one second conductive component disposed within the at least one second dielectric layer. The at least one second dielectric layer and the at least one second conductive component being built up onto the second surface of the core body.

It is to be appreciated that use of terms such as upper, lower, top, bottom and the like are meant to provide an orientation for the reader to more easily describe various features of the disclosure, and are not intended to limit the scope of the application or embodiment. Additionally, components that are "disposed at" a surface may be on top of, below, partially below, partially above, and generally adjacent the identified surface.

Unless otherwise stated, the foregoing alternative examples are not mutually exclusive, but may be implemented in various combinations to achieve unique advantages. As these and other variations and combinations of the features discussed above can be utilized without departing from the subject matter defined by the claims, the foregoing description should be taken by way of illustration rather than by way of limitation of the subject matter defined by the claims. In addition, the provision of the examples described herein, as well as clauses phrased as "such as," "including," and the like, should not be interpreted as limiting the subject matter of the claims to the specific examples; rather, the examples are intended to illustrate only some of many possible implementations. Further, the same or similar reference numbers in different drawings can identify the same or similar elements.

## Claims

1. A package substrate for a microelectronic package assembly comprising:
an inorganic core body having a top surface and a bottom surface;
at least one core via extending through the top and bottom surfaces of the core body;
at least one built-up redistribution layer built up on one of the top surface or the bottom surface of the inorganic core body, the redistribution layer comprising at least one dielectric layer, a plurality of conductive traces and contacts overlying the at least one dielectric layer, and redistribution vias extending through the at least one dielectric layer; and
at least one capacitor structure embedded within the inorganic core body and extending between the top and bottom surfaces of the inorganic core body, the at least one capacitor structure comprising at least two conductive layers and a capacitor dielectric layer disposed between the at least two conductive layers,
wherein the at least one core via conductively connects first terminals disposed at a top surface of the substrate with second terminals disposed at a bottom surface of the substrate.

2. The package substrate of claim 1, wherein the inorganic core body comprises a ceramic material; and/or
wherein the ceramic material is comprised substantially of one of the following materials: aluminum oxide (Al2O3), aluminum nitride (AlN), silicon nitride (Si3N4), silicon carbide (SiC), and zirconia oxide (ZrO2).

3. The package substrate of claim 1 or 2, wherein the at least one capacitor structure has a length extending between the top and bottom surfaces of the core body that is at least 5% of a total length of the core body, wherein the total length is a length between the top surface and the bottom surface of the core body.

4. The package substrate of any one of claims 1 to 3, wherein a minimum width of at least some of the plurality of conductive traces is less than 5µm; and/or
wherein a minimum width of at least one conductive trace of the plurality of conductive traces is less than 2µm; and/or wherein a minimum gap between at least one conductive trace of the plurality of conductive traces and another conductive element along a same plane is less than 5µm; and/or
wherein the minimum gap between at least one conductive trace of the plurality of conductive traces and another conductive element disposed along a same plane is less than 2µm.

5. The package substrate of any one of claims 1 to 4, wherein at least one conductive layer of the at least two conductive layers of the capacitor structure has a length extending in a direction between the top and bottom surfaces of the core body that is at least 10 times a thickness of the at least one conductive layer that extends in a direction perpendicular to its length.

6. The package substrate of any one of claims 1 to 5, wherein the dielectric capacitor layer comprises a dielectric constant greater than 5; and/or
wherein terminals of the capacitor structure are disposed at the top and bottom surfaces of the core body.

7. A microelectronic package assembly comprising:
the package substrate of any one of claims 1 to 6; and
at least one integrated circuit chip bonded to the substrate, wherein the at least one integrated circuit chip is conductively connected to at least one of the conductive traces disposed at the substrate.

8. The assembly of claim 7, wherein at least one electrical interconnect is disposed at a top surface or a bottom surface of the package substrate.

9. The assembly of claim 7 or 8, wherein the at least one integrated circuit chip comprises one of a central processing unit (CPU) chip, graphics processing units (GPUs) chip, field programmable gate array ship (FPGAs), and application-specific integrated circuit (ASIC) chip; and/or
wherein the at least one integrated circuit chip is an ASIC comprising a tensor processing unit chip; and/or
wherein the at least one integrated circuit chip is a first chip, and the assembly further comprises a second plurality of integrated circuit chips stacked one on top of the other and conductively connected to the first chip through the package substrate.

10. A method of manufacturing a package substrate for a chip package assembly, the method comprising:
forming one or more capacitor structures within an inorganic core body, the forming comprising:
depositing a first conductive layer along an interior surface of a plurality of openings within the core body;
depositing a second dielectric layer within the plurality of openings, the dielectric layer overlying the first conductive layer, the dielectric layer comprising a dielectric material having a high dielectric constant; and
filling a remainder of the plurality of openings with a third conductive layer, such that the third conductive layer is insulated from the first conductive layer by the second dielectric layer;
forming a conductive through-via within one of the plurality of openings, the one of the plurality of openings extending through the top surface and bottom surface of the core body;
building a redistribution layer directly onto the inorganic core body, the building comprising:
depositing a dielectric layer directly onto the core body;
patterning the dielectric layer to form a plurality of openings; and
filling the openings with conductive material to form conductive interconnections.

11. The method of claim 10, wherein the patterning comprising forming some of the plurality of openings into a trace pattern, and filling the openings includes filling the some of the plurality openings with conductive material to form conductive traces.

12. The method of claim 11, wherein the patterning further comprises forming other of the plurality of openings into through via openings that extend between top and bottom surfaces of the dielectric layer, and filling the openings includes filling the other of the plurality of openings with conductive material to form conductive vias.

13. The method of claim 11 or 12, further comprises forming other of the plurality of openings into via openings that extend between top and bottom surfaces of the dielectric layer, and filling the openings includes filling the via openings with conductive material to form terminals of the package substrate.

14. The method of claim 12 or 13, wherein the depositing a dielectric layer comprises depositing a first dielectric layer, and the method further comprises:
depositing a second dielectric layer directly onto the first dielectric layer;
patterning the dielectric layer to form a second plurality of via openings and a second plurality of trace openings; and
filling the second plurality of via openings and the second plurality of trace openings with conductive material so as to respectively form conductive vias and conductive traces.

15. The method of any one of claims 12 to 14, wherein the depositing a dielectric layer comprises depositing a first dielectric layer, and the method further comprises:
depositing a second dielectric layer overlying the first dielectric layer;
patterning the second dielectric layer to form a second plurality of via openings; and
filling the second plurality of via openings with conductive material so as to form conductive vias, at least some of the vias forming terminals of the package substrate.
